# EUROPÄISCHE PATENTSCHRIFT

(11) **EP 3 284 109 B1**
(45) Veröffentlichungstag und Bekanntmachung des Hinweises auf die Patenterteilung: **19.06.2019**
(21) Anmeldenummer: 16712730.7
(22) Anmeldetag: 24.03.2016
(51) Int. Cl.: H01L 31/04

(54) **VERFAHREN ZUR HERSTELLUNG VON SOLARZELLEN UNTER VERWENDUNG VON PHOSPHOR-DIFFUSIONSHEMMENDEN, DRUCKBAREN DOTIERMEDIEN**
METHOD FOR PRODUCING SOLAR CELLS USING PHOSPHORUS DIFFUSION-INHIBITING, PRINTABLE DOPING MEDIA
PROCÉDÉ DE FABRICATION DE CELLULES PHOTOVOLTAÏQUES À L'AIDE DE MILIEUX DOPANT INHIBANT LA DIFFUSION DU PHOSPHORE ET IMPRIMABLES

(30) Priorität: 15.04.2015 EP 15001072; 12.08.2015 EP 15180689
(43) Veröffentlichungstag der Anmeldung: 21.02.2018
(73) Patentinhaber: Merck Patent GmbH, 64293 Darmstadt (DE)
(72) Erfinder: DOLL, Oliver, 63128 Dietzenbach (DE); KOEHLER, Ingo, 64291 Darmstadt (DE); BARTH, Sebastian, 64291 Darmstadt (DE)
(86) Internationale Anmeldenummer: PCT/EP2016/000517
(87) Internationale Veröffentlichungsnummer: WO 2016/165811

(56) Entgegenhaltungen:
- WO-A1-2014/101990
- WO-A2-2012/119684

## Beschreibung

Die vorliegende Erfindung betrifft ein neues druckbares Medium in Form eines Hybridsols und/oder -gels auf Basis von Precursoren anorganischer Oxide zur Verwendung in einem vereinfachten Verfahren zur Herstellung von Solarzellen, worin das erfindungsgemäße Medium sowohl als Dotiermedium als auch als Diffusionsbarriere fungiert.

### Stand der Technik

Die Herstellung von einfachen bzw. der derzeit im Markt mit größtem Marktanteil vertretenen Solarzellen umfasst die im Folgenden skizzierten wesentlichen Herstellungsschritte:

### 1) Sägeschadensätzung und Textur

Ein Siliziumwafer (monokristallin, multikristallin oder quasi-monokristallin, Basisdotierung p- oder n-Typ) wird mittels Ätzverfahren von anhaftenden Sägeschädigung befreit und "zeitgleich", im Regelfall in dem gleichen Ätzbad, texturiert. Unter Texturierung ist in diesem Fall die Schaffung einer vorzugsorientierten Oberfläche(nbeschaffenheit) in Folge des Ätzschrittes oder einfach die gezielte, aber nicht besonders orientierte Aufrauhung der Waferoberfläche zu verstehen. In Folge der Texturierung wirkt die Oberfläche des Wafers nun als ein diffuser Reflektor und mindert somit die gerichtete, wellenlängen- und vom Winkel des Auftreffens abhängige Reflexion, was letztlich zu einer Erhöhung des absorbierten Anteils des auf die Oberfläche auftreffenden Lichtes führt und somit die Konversionseffizienz der Solarzelle erhöht.

Die vorher erwähnten Ätzlösungen zur Behandlung der Siliziumwafer bestehen im Falle monokristalliner Wafer typischerweise aus verdünnter Kalilauge, der als Lösungsmittel Isopropylalkohol zugesetzt ist. Es können stattdessen auch andere Alkohole mit höherem Dampfdruck oder höherem Siedepunkt als Isopropylalkohol hinzugefügt sein, sofern dadurch das gewünschte Ätzergebnis erzielt werden kann. Als gewünschtes Ätzergebnis erhält man typischerweise eine Morphologie, die von zufällig angeordneten, oder vielmehr aus der ursprünglichen Oberfläche herausgeätzten, Pyramiden mit quadratischer Grundfläche gekennzeichnet ist. Die Dichte, die Höhe und damit Grundfläche der Pyramiden kann durch geeignete Wahl der oben erwähnten Inhaltsstoffe der Ätzlösung, die Ätztemperatur und die Verweildauer der Wafer im Ätzbecken mit beeinflusst werden. Typischerweise wird die Texturierung der monokristallinen Wafer im Temperaturbereich von 70 - <90 °C durchgeführt, wobei Ätzabträge von bis zu 10 µm pro Waferseite erzielt werden können.

Im Falle multikristalliner Siliziumwafer kann die Ätzlösung aus Kalilauge mit mittlerer Konzentration (10 - 15 %) bestehen. Diese Ätztechnik wird in der industriellen Praxis aber kaum noch angewandt. Häufiger wird eine Ätzlösung bestehend aus Salpetersäure, Flusssäure und Wasser verwendet. Diese Ätzlösung kann durch verschiedene Additive, wie beispielsweise Schwefelsäure, Phosphorsäure, Essigsäure, N-Methylpyrrolidon und auch Tensiden, modifiziert werden, womit u. a. Benetzungseigenschaften der Ätzlösung als auch deren Ätzrate gezielt beeinflusst werden können. Diese sauren Ätzmischungen erzeugen auf der Oberfläche eine Morphologie von in sich verschachtelt angeordneter Ätzgruben. Die Ätzung wird typischerweise bei Temperaturen im Bereich zwischen 4 °C bis <10 °C durchgeführt und der Ätzabtrag beträgt hier im Regelfall 4 µm bis 6 µm.

Direkt im Anschluss an die Texturierung werden die Siliziumwafer mit Wasser intensiv gereinigt und mit verdünnter Flusssäure behandelt, um die in Folge der vorhergehenden Behandlungsschritte entstandene chemische Oxidschichtschicht und darin als auch daran absorbierte und adsorbierte Verunreinigungen zur Vorbereitung der nachfolgenden Hochtemperaturbehandlung zu entfernen.

### 2) Diffusion und Dotierung

Die im vorhergehenden Schritt geätzten und gereinigten Wafer (in diesem Fall p-Typ Basisdotierung) werden bei höheren Temperaturen, typischerweise zwischen 750 °C und <1000 °C, mit Dampf, bestehend aus Phosphoroxid, behandelt. Dabei werden die Wafer in einen Rohrofen in einer Quarzglasröhre einer kontrollierten Atmosphäre, bestehend aus getrocknetem Stickstoff, getrocknetem Sauerstoff und Phosphorylchlorid, ausgesetzt. Die Wafer werden dazu bei Temperaturen zwischen 600 und 700 °C in das Quarzglasrohr eingebracht. Die Gasmischung wird durch das Quarzglasrohr transportiert. Während des Transportes der Gasmischung durch das stark erwärmte Rohr zerfällt das Phosphorylchlorid zu einem Dampf, bestehend aus Phosphoroxid (z. B. P2O5) und Chlorgas. Der Dampf aus Phosphoroxid schlägt sich u. a. auf den Waferoberflächen nieder (Belegung). Zeitgleich wird die Siliziumoberfläche bei diesen Temperaturen unter Bildung einer dünnen Oxidschicht oxidiert. In diese Schicht wird das niedergeschlagene Phosphoroxid eingebettet, wodurch eingemischtes Oxid aus Siliziumdioxid und Phosphoroxid auf der Waferoberfläche entsteht. Dieses Mischoxid wird als Phosphorsilikatglas (PSG) bezeichnet. Dieses PSG-Glas verfügt in Abhängigkeit von der Konzentration des enthaltenen Phosphoroxids über unterschiedliche Erweichungspunkte und unterschiedliche Diffusionskonstanten hinsichtlich des Phosphoroxides. Das Mischoxid dient dem Siliziumwafer als Diffusionsquelle, wobei im Verlauf der Diffusion das Phosphoroxid in Richtung der Grenzfläche zwischen PSG-Glas und Siliziumwafer diffundiert und dort durch Reaktion mit dem Silizium an der Waferoberfläche (silizothermisch) zu Phosphor reduziert wird. Das derart entstandene Phosphor verfügt über eine um Größenordnungen höhere Löslichkeit in Silizium als in der Glasmatrix, aus der es entstanden ist und löst sich dadurch aufgrund des sehr hohen Segregationskoeffizienten bevorzugt im Silizium. Nach dessen Lösung diffundiert der Phosphor im Silizium entlang des Konzentrationsgradienten in das Volumen des Siliziums ein. Bei diesem Diffusionsprozess entstehen Konzentrationsgradienten in der Größenordnung von 105 zwischen typischen Oberflächenkonzentrationen von 1021 Atomen/cm² und der Basisdotierung im Bereich von 1016 Atomen/cm². Die typische Diffusionstiefe beträgt 250 bis 500 nm und ist von der gewählten Diffusionstemperatur (beispielsweise 880 °C) und der Gesamtexpositionsdauer (Aufheizen & Belegungsphase & Eintreibephase & Abkühlen) der Wafer in der stark erwärmten Atmosphäre abhängig. Während der Belegungsphase entsteht eine PSG-Schicht, die eine typischer Weise eine Schichtdicke von 40 bis 60 nm aufweist. Im Anschluss an die Belegung der Wafer mit dem PSG-Glas, während derer bereits auch eine Diffusion in das Volumen des Siliziums stattfindet, folgt die Eintreibephase. Diese kann von der Belegungsphase entkoppelt werden, wird jedoch praktischerweise im Regelfall zeitlich unmittelbar an die Belegung gekoppelt und findet üblicherweise deshalb auch bei der gleichen Temperatur statt. Dabei wird die Zusammensetzung der Gasmischung so angepasst, dass die weitere Zufuhr von Phosphorylchlorids unterbunden wird. Während des Eintreibens wird die Oberfläche des Siliziums durch den in der Gasmischung enthaltenen Sauerstoff weiter oxidiert, wodurch zwischen der eigentlichen Dotierquelle, dem an Phosphoroxid stark angereicherten PSG-Glas und dem Siliziumwafer eine an Phosphoroxid abgereicherte Siliziumdioxidschicht generiert wird, die ebenfalls Phosphoroxid enthält. Das Wachstum dieser Schicht ist im Verhältnis zum Massenstrom des Dotierstoffes aus der Quelle (PSG-Glas) sehr viel schneller, weil das Oxidwachstum durch die hohe Oberflächendotierung des Wafers selbst beschleunigt wird (Beschleunigung um eine bis zwei Größenordnungen). Dadurch wird in gewisser Weise eine Verarmung oder Separierung der Dotierquelle erzielt, deren Durchdringung mit herandiffundierendem Phosphoroxid von dem Stoffstrom beeinflusst wird, der von der Temperatur und damit dem Diffusionskoeffizienten abhängig ist. Auf diese Weise kann die Dotierung des Siliziums in gewissen Grenzen kontrolliert werden. Eine typische Diffusionsdauer bestehend aus Belegungs- und Eintreibephase beträgt beispielsweise 25 Minuten. Im Anschluss an diese Behandlung wird der Rohrofen automatisch abgekühlt und die Wafer können bei Temperaturen zwischen 600 °C bis 700 °C aus dem Prozessrohr ausgeschleust werden.

Im Falle einer Bordotierung der Wafer in Form einer n-Typ-Basisdotierung, wird ein anderes Verfahren durchlaufen, das hier nicht gesondert erläutert werden soll. Die Dotierung wird in diesen Fällen beispielsweise mit Bortrichlorid oder Bortribromid durchgeführt. Je nach Wahl der Zusammensetzung der zur Dotierung eingesetzten Gasatmosphäre, kann die Bildung einer sogenannten Borhaut auf den Wafern festgestellt werden. Diese Borhaut ist von verschiedenen Einflussfaktoren abhängig: maßgeblich der Dotieratmosphäre, der Temperatur, der Dotierdauer, der Quellkonzentration und den gekoppelten (oder linearkombinierten) zuvor genannten Parametern.

Bei solchen Diffusionsprozessen versteht es sich von selbst, dass es bei den verwendeten Wafern keine Bereiche bevorzugter Diffusion und Dotierung geben kann (ausgenommen solcher, die durch inhomogene Gasflüsse und daraus resultierende inhomogen zusammengesetzte Gaspakete entstanden sind), sofern die Substrate nicht im Vorfeld einer entsprechenden Vorbehandlung unterworfen wurden (beispielsweise deren Strukturierung mit diffusionshemmenden und/oder -unterbindenden Schichten und Materialien).

Der Vollständigkeit halber sei hier noch darauf verwiesen, dass es noch weitere Diffusions- und Dotiertechnologien gibt, welche sich unterschiedlich stark in der Herstellung kristalliner Solarzellen auf Basis von Silizium etabliert haben. So seien erwähnt,
- die Ionenimplantation,
- die Dotierung, vermittelt über die Gasphasendeposition von Mischoxiden, wie beispielsweise deren von PSG- und BSG-(Borosilicat-)Glas, mittels APCVD-, PECVD-, MOCVD- und LPCVD-Verfahren,
- (Co-)Sputtering von Mischoxiden und/oder keramischen Materialien und Hartstoffen (z. B. Bornitrid), der Gasphasendeposition beider letztgenannter, - der rein thermischen Gasphasendeposition ausgehend von festen Dotierstoffquellen (z. B. Boroxid und Bornitrid) sowie
- der Flüssigphasendeposition von dotierend wirkenden Flüssigkeiten (Tinten) und Pasten.

Letztere werden häufig bei der sogenannten inline-Dotierung verwendet, bei der die entsprechenden Pasten und Tinten auf der zu dotierenden Seite des Wafers mittels geeigneten Verfahren aufgetragen werden. Nach dem oder auch bereits während des Auftragens werden die in den zur Dotierung eingesetzten Zusammensetzungen enthaltenen Lösungsmittel durch Temperatur- und/oder Vakuumbehandlung entfernt. Hierdurch bleibt der eigentliche Dotierstoff auf der Waferoberfläche zurück. Als flüssige Dotierquellen können beispielsweise verdünnte Lösungen von Phosphor- oder Borsäure, als auch Sol-Gel-basierte Systeme oder auch Lösungen polymerer Borazilverbindungen eingesetzt werden. Entsprechende Dotierpasten sind fast ausschließlich durch die Verwendung von zusätzlichen verdickend wirkenden Polymeren gekennzeichnet, und enthalten Dotierstoffe in geeigneter Form. An die Verdampfung der Solventien aus den zuvor genannten Dotiermedien schließt sich meist eine Behandlung bei hoher Temperatur an, während derer unerwünschte und störende, aber die Formulierung bedingende, Zuschlagsstoffe entweder "verbrannt" und/oder pyrolysiert werden. Die Entfernung von Lösungsmitteln und das Ausbrennen können, müssen aber nicht, simultan erfolgen. Anschließend passieren die beschichteten Substrate üblicherweise einen Durchlaufofen bei Temperaturen zwischen 800 °C und 1000 °C, wobei zur Verkürzung der Durchlaufzeit die Temperaturen im Vergleich zur Gasphasendiffusion im Rohrofen leicht erhöht sein können. Die in dem Durchlaufofen vorherrschende Gasatmosphäre kann gemäß den Erfordernissen der Dotierung unterschiedlich sein und aus trockenem Stickstoff, trockener Luft, einem Gemisch aus trockenem Sauerstoff und trockenem Stickstoff und/oder, je nach Ausführung des zu passierenden Ofens, aus Zonen der einen und anderen der oben genannten Gasatmosphären bestehen. Weitere Gasmischungen sind vorstellbar, besitzen aber industriell derzeit keine größere Bedeutung. Ein Charakteristikum der inline-Diffusion ist, dass die Belegung und das Eintreiben des Dotierstoffes prinzipiell voneinander entkoppelt erfolgen können.

### 3) Entfernung der Dotierstoffquelle und optionale Kantenisolation

Die nach der Dotierung vorliegenden Wafer sind beidseitig mit mehr oder weniger Glas auf beiden Seiten der Oberfläche beschichtet. Mehr oder weniger bezieht sich in diesem Fall auf Modifikationen, die im Rahmen des Dotierprozesses angewendet werden können: Doppelseiten-Diffusion vs. quasi einseitiger Diffusion vermittelt durch back-to-back Anordnung zweier Wafer in einem Stellplatz der verwendeten Prozessboote. Die letztere Variante ermöglicht eine vorwiegend einseitige Dotierung, unterbindet die Diffusion auf der Rückseite jedoch nicht vollständig. In beiden Fällen ist es derzeit Stand der Technik die nach der Dotierung vorliegenden Gläser mittels Ätzens in verdünnter Flusssäure von den Oberflächen zu entfernen. Dazu werden die Wafer einerseits chargenweise in Nassprozessboote umgeladen und mit deren Hilfe in eine Lösung aus verdünnter Flusssäure, typischerweise 2 %ig bis 5 %ig, eingetaucht und in dieser so lange belassen, bis entweder die Oberfläche vollständig von dem Gläsern befreit ist, oder die Prozesszyklendauer abgelaufen ist, die ein Summenparameter aus der notwendigen Ätzdauer und der maschinellen Prozessautomatisierung darstellt. Die vollständige Entfernung der Gläser kann beispielsweise anhand der vollständigen Entnetzung der Siliziumwaferoberfläche durch die verdünnte wässrige Flusssäurelösung festgestellt werden. Die vollständige Entfernung eines PSG-Glases wird unter diesen Prozessbedingungen beispielsweise mit 2 %-iger Flusssäurelösung innerhalb von 210 Sekunden bei Raumtemperatur erreicht. Die Ätzung entsprechender BSG-Gläser ist langsamer und erfordert längere Prozesszeiten und ggfs. auch höhere Konzentrationen der zum Einsatz gelangenden Flusssäure. Nach der Ätzung werden die Wafer mit Wasser gespült.

Andererseits kann die Ätzung der Gläser auf den Waferoberflächen auch in einem horizontal operierenden Verfahren erfolgen, bei dem die Wafer in einem konstanten Fluss in eine Ätzanlage eingeführt werden, in welcher die Wafer die entsprechenden Prozessbecken horizontal durchlaufen (inline-Anlage). Dabei werden die Wafer auf Rollen und Walzen entweder durch die Prozessbecken und die darin enthaltenen Ätzlösungen gefördert oder die Ätzmedien mittels Walzenauftrag auf die Waferoberflächen transportiert. Die typische Verweildauer der Wafer beträgt im Falle des Ätzens des PSG-Glases etwa 90 Sekunden, und die zur Anwendung kommende Flusssäure ist etwas höher konzentriert als bei dem chargenweise arbeitenden Verfahren, um die kürzere Verweildauer infolge einer erhöhten Ätzrate zu kompensieren. Die Konzentration der Flusssäure beträgt typischerweise 5 %. Optional kann zusätzlich die Beckentemperatur gegenüber der Raumtemperatur leicht erhöht vorliegen (> 25 °C < 50 °C).

Bei dem zuletzt skizzierten Verfahren hat es sich etabliert, die sogenannte Kantenisolation sequentiell gleichzeitig mit durchzuführen, wodurch sich ein leicht abgewandelter Prozessfluss ergibt: Kantenisolation → Glasätzung. Die Kantenisolation ist eine prozesstechnische Notwendigkeit, die sich aus der systemimmanenten Charakteristik der doppelseitigen Diffusion, auch bei beabsichtigter einseitiger back-to-back Diffusion, ergibt. Auf der (späteren) Rückseite der Solarzelle liegt ein großflächiger parasitärer p-n-Übergang vor, der zwar, prozesstechnisch bedingt, teilweise, aber nicht vollständig im Laufe der späteren Prozessierung entfernt wird. Als Folge davon werden die Vorder- und Rückseite der Solarzelle über einen parasitären und verbleibenden p-n-Übergang (Tunnelkontakt) kurzgeschlossen sein, der die Konversionseffizienz der späteren Solarzelle reduziert. Zur Entfernung dieses Übergangs werden die Wafer einseitig über eine Ätzlösung bestehend aus Salpetersäure und Flusssäure geführt. Die Ätzlösung kann als Nebenbestandteile beispielsweise Schwefelsäure oder Phosphorsäure enthalten. Alternativ wird die Ätzlösung über Walzen vermittelt auf die Rückseite des Wafers transportiert. Der typischerweise bei diesen Verfahren erzielte Ätzabtrag beträgt bei Temperaturen zwischen 4 °C bis 8 °C etwa 1 µm Silizium (inklusive der auf der zu behandelnden Oberfläche vorliegenden Glasschicht). Bei diesem Verfahren dient die auf der gegenüberliegenden Seite des Wafers noch vorhandene Glasschicht als Maske, die vor Ätzübergriffen auf diese Seite einen gewissen Schutz ausübt. Diese Glasschicht wird im Anschluss mit Hilfe der bereits beschriebenen Glasätzung entfernt.

Darüber hinaus kann die Kantenisolation auch mit Hilfe von Plasmaätzprozessen durchgeführt werden. Diese Plasmaätzung wird dann in der Regel vor der Glasätzung durchgeführt. Dazu werden mehrere Wafer aufeinander gestapelt und die Außenkanten werden dem Plasma ausgesetzt. Das Plasma wird mit fluorierten Gasen, beispielsweise Tetrafluormethan, gespeist. Die beim Plasmazerfall dieser Gase auftretenden reaktiven Spezies ätzen die Kanten des Wafers. Im Anschluss an die Plasmaätzung wird dann im Allgemeinen die Glasätzung durchgeführt.

### 4) Beschichtung der Frontseite mit einer Antireflexionsschicht

Im Anschluss an die Ätzung des Glases und die optional erfolgte Kantenisolation findet die Beschichtung der Frontseite der späteren Solarzellen mit einer Antireflexionsbeschichtung statt, die üblicherweise aus amorphem und wasserstoffreichem Siliziumnitrid besteht. Alternative Antireflexionbeschichtungen sind vorstellbar. Mögliche Beschichtungen können Titandioxid, Magnesiumfluorid, Zinndioxid und/oder aus entsprechenden Stapelschichten aus Siliziumdioxid und Siliziumnitrid bestehen. Es sind aber auch anders zusammengesetzte Antireflexionbeschichtungen technisch möglich. Die Beschichtung der Waferoberfläche mit dem oben erwähnten Siliziumnitrid erfüllt im Wesentlichen zwei Funktionen: einerseits generiert die Schicht aufgrund der zahlreichen inkorporierten positiven Ladungen ein elektrisches Feld, dass Ladungsträger im Silizium von der Oberfläche fern halten kann und die Rekombinationsgeschwindigkeit dieser Ladungsträger an der Siliziumoberfläche erheblich reduzieren kann (Feldeffektpassivierung), andererseits generiert diese Schicht in Abhängigkeit von ihren optischen Parametern, wie beispielsweise Brechungsindex und Schichtdicke, eine reflexionsmindernde Eigenschaft, die dazu beiträgt, dass in die spätere Solarzelle mehr Licht eingekoppelt werden kann. Durch beide Effekte kann die Konversionseffizienz der Solarzelle erhöht werden. Typische Eigenschaften der derzeit verwendeten Schichten sind: eine Schichtdicke von ∼80 nm bei Verwendung von ausschließlich dem oben genannten Siliziumnitrid, welches einen Brechungsindex von etwa 2,05 aufweist. Die Antireflexionsminderung zeigt sich am deutlichsten im Wellenlängenbereich des Lichtes von 600 nm. Die gerichtete und ungerichtete Reflexion zeigt hierbei einen Wert von etwa 1 % bis 3 % des ursprünglich einfallenden Lichtes (senkrechter Einfall zur Oberflächennormalen des Siliziumwafers).

Die oben erwähnten Siliziumnitridschichten werden zurzeit im Allgemeinen mittels direktem PECVD-Verfahren auf der Oberfläche deponiert. Dazu wird einer Gasatmosphäre aus Argon ein Plasma gezündet, in welches Silan und Ammoniak eingeleitet werden. Das Silan und das Ammoniak werden in dem Plasma über ionische und radikalische Reaktionen zu Siliziumnitrid umgesetzt und dabei auf der Waferoberfläche deponiert. Die Eigenschaften der Schichten können z. B. über die individuellen Gasflüsse der Reaktanden eingestellt und kontrolliert werden. Die Abscheidung der oben erwähnten Siliziumnitridschichten kann auch mit Wasserstoff als Trägergas und/oder den Reaktanden allein erfolgen. Typische Abscheidetemperaturen liegen im Bereich zwischen 300 °C bis 400 °C. Alternative Abscheidemethoden können beispielsweise LPCVD und/oder Sputtern sein.

### 5) Erzeugung des Frontseitenelektrodengitters

Nach der Deponierung der Antireflexionsschicht wird auf der mit Siliziumnitrid beschichteten Waferoberfläche die Frontseitenelektrode definiert. In der industriellen Praxis hat es sich etabliert, die Elektrode mit Hilfe der Siebdruckmethode unter Verwendung von metallischen Sinterpasten zu erzeugen. Dieses ist jedoch nur eine von vielen verschiedenen Möglichkeiten die gewünschten Metallkontakte herzustellen.

Bei der Siebdruckmetallisierung wird in der Regel eine stark mit Silberpartikeln angereicherte Paste (Silberanteil <= 80 %) verwendet. Die Summe der Restbestandteile ergibt sich aus den zur Formulierung der Paste notwendigen rheologischen Hilfsmitteln, wie zum Beispiel Lösemittel, Binde- und Verdickungsmittel. Weiterhin enthält die Silberpaste einen spezielle Glasfrit-Mischung, meistens Oxide und Mischoxide auf der Basis von Siliziumdioxid, Borosilicatglas als auch Bleioxid und/oder Bismutoxid. Die Glasfrit erfüllt im Wesentlichen zwei Funktionen: sie dient einerseits als Haftvermittler zwischen der Waferoberfläche und der Masse der zu versinternden Silberpartikel, andererseits ist sie für die Penetration der Siliziumnitriddeckschicht verantwortlich, um den direkten ohm'schen Kontakt zu dem darunter befindlichen Silizium zu ermöglichen. Die Penetration des Siliziumnitrids erfolgt über einen Ätzprozess mit anschließender Diffusion von in der Glasfritmatrix gelöst vorliegendem Silber in die Siliziumoberfläche, wodurch die ohm'sche Kontaktbildung erzielt wird. In der Praxis wird die Silberpaste mittels Siebdruckens auf der Waferoberfläche deponiert und anschließend bei Temperaturen von etwa 200 °C bis 300 °C für wenige Minuten getrocknet. Der Vollständigkeit halber sei erwähnt, dass auch Doppeldruckprozesse industrielle Anwendung finden, die es ermöglichen, auf ein während des ersten Druckschrittes generiertes Elektrodengitter, ein deckungsgleiches zweites aufzudrucken. Somit wird die Stärke der Silbermetallisierung erhöht, was die Leitfähigkeit in dem Elektrodengitter positiv beeinflussen kann. Während dieser Trocknung werden die in der Paste enthaltenen Lösemittel aus der Paste ausgetrieben. Anschließend passiert der bedruckte Wafer einen Durchlaufofen. Ein solcher Ofen verfügt im Allgemeinen über mehrere Heizzonen, die unabhängig voneinander angesteuert und temperiert werden können. Beim Passivieren des Durchlaufofens werden die Wafer auf Temperaturen bis etwa 950 °C erhitzt. Der einzelne Wafer wird jedoch im Regelfall dieser Spitzentemperatur nur für wenige Sekunden ausgesetzt. Während der verbleibenden Druchlaufphase weist der Wafer Temperaturen von 600 °C bis 800 °C auf. Bei diesen Temperaturen werden in der Silberpaste enthaltene organische Begleitstoffe, wie beispielsweise Bindemittel, ausgebrannt und die Ätzung der Siliziumnitridschicht wird initiiert. Während des kurzen Zeitintervalls der vorherrschenden Spitzentemperaturen findet die Kontaktbildung zum Silizium statt. Anschließend lässt man die Wafer abkühlen.

Der so kurz skizzierte Prozess der Kontaktbildung üblicherweise simultan mit den beiden verbleibenden Kontaktbildungen (vgl. 6 und 7) durchgeführt, weshalb man in diesem Fall auch von einem Ko-Feuerungsprozess spricht.

Das frontseitige Elektrodengitter besteht an sich aus dünnen Fingern (typische Anzahl >= 68), die eine Breite von typischerweise 80 µm bis 140 µm aufweisen, als auch sammelnden Bussen mit Breiten im Bereich von 1,2 mm bis 2,2 mm (abhängig von deren Anzahl, typischerweise zwei bis drei). Die typische Höhe der gedruckten Silberelemente beträgt in der Regel zwischen 10 µm und 25 µm. Das Aspektverhältnis ist selten größer als 0,3.

### 6) Erzeugung der rückseitigen Sammelbusse

Die rückseitigen Sammelbusse werden in der Regel ebenfalls mittels Siebdruckverfahren aufgebracht und definiert. Dazu findet eine der zur frontseitigen Metallisierung verwendeten ähnliche Silberpaste Anwendung. Diese Paste ist ähnlich zusammengesetzt, enthält aber eine Legierung aus Silber und Aluminium, worin der Anteil des Aluminiums typischerweise 2 % ausmacht. Daneben enthält diese Paste einen geringeren Glasfrit-Anteil. Die Sammelbusse, in der Regel zwei Stück, werden mit einer typischen Breite von 4 mm auf der Rückseite des Wafers mittels Siebdruck aufgedruckt werden und wie bereits unter Punkt 5 beschrieben verdichtet und versintert werden.

### 7) Erzeugung der rückseitigen Elektrode

Die rückseitige Elektrode wird im Anschluss an den Druck der Sammelbusse definiert. Das Elektrodenmaterial besteht aus Aluminium, weswegen zur Definition der Elektrode eine aluminiumhaltige Paste mittels Siebdruck auf der verbleibenden freien Fläche der Waferrückseite mit einem Kantenabstand <1mm aufgedruckt wird. Die Paste ist zu <= 80 % aus Aluminium zusammengesetzt. Die restlichen Komponenten sind solche, die bereits unter Punkt 5 erwähnt worden sind(wie z. B. Lösemittel, Bindemittel etc.). Die Aluminiumpaste wird während der Ko-Feuerung mit dem Wafer verbunden, indem während der Erwärmung die Aluminiumpartikel zu schmelzen beginnen und sich Silizium von dem Wafer in dem geschmolzenen Aluminium auflöst. Die Schmelzmischung fungiert als Dotierstoffquelle und gibt Aluminium an das Silizium ab (Löslichkeitsgrenze: 0,016 Atomprozent), wobei das Silizium infolge dieses Eintriebs p+ dotiert wird. Beim Abkühlen des Wafers scheidet sich auf der Waferoberfläche u. a. eine eutektische Mischung aus Aluminium und Silizium ab, die bei 577 °C erstarrt und eine Zusammensetzung mit einem Molenbruch von 0,12 Si aufweist.

Infolge des Eintreibens des Aluminiums in das Silizium entsteht auf der Rückseite des Wafers eine hochdotierte p-Typ-Schicht, die auf Teile der freien Ladungsträger im Silizium als eine Art Spiegel fungiert ("elektrischer Spiegel"). Diese Ladungsträger können diesen Potentialwall nicht überwinden und werden somit sehr effizient von der rückwärtigen Waferoberfläche ferngehalten, was sich somit in einer insgesamt reduzierten Rekombinationsrate von Ladungsträgern an dieser Oberfläche äußert. Dieser Potentialwall wird im Allgemeinen als Rückseitenfeld oder back surface field bezeichnet.

Die Abfolge der Verfahrensschritte, die unter den Punkten 5, 6 und 7 beschrieben sind, kann der hier skizzierten Reihenfolge entsprechen, muss es aber nicht. Dem Fachmann ist ersichtlich, dass die Abfolge der geschilderten Prozessschritte im Prinzip in jeder vorstellbaren Kombinatorik ausgeführt werden können.

### 8) Optionale Kantenisolation

Sofern die Kantenisolation des Wafer nicht bereits, wie unter Punkt 3 beschrieben, erfolgt ist, wird diese typischerweise nach dem Ko-Feuern mit Hilfe von Laserstrahlverfahren durchgeführt. Dazu wird ein Laserstrahl auf die Vorderseite der Solarzelle dirigiert und der frontseitige p-n-Übergang wird mit Hilfe der durch diesen Strahl eingekoppelten Energie durchtrennt. Dabei werden Schnittgräben mit einer Tiefe von bis zu 15 µm infolge der Einwirkung des Lasers generiert. Dabei wird Silizium über einen Ablationsmechanismus von der behandelten Stelle entfernt bzw. aus dem Lasergraben geschleudert. Typischerweise ist dieser Lasergraben 30 µm bis 60 µm breit und etwa 200 µm von der Kante der Solarzelle entfernt.

Nach ihrer Herstellung werden die Solarzellen charakterisiert und entsprechend ihrer individuellen Leistungen in einzelne Leistungskategorien klassiert.

Der Fachmann kennt Solarzellenarchitekturen mit sowohl n-Typ als auch p-typ-Basismaterial. Zu diesen Solarzellentypen zählen u. a.
- PERC-Solarzellen
- PERL-Solarzellen
- PERT-Solarzellen
- daraus folgernd MWT-PERT- und MWT-PERL-Solarzellen
- Bifaciale Solarzellen
- Rückseitenkontaktzellen
- Rückseitenkontaktzellen mit interdigitierenden Kontakten (IBC-Zellen)

Auch die Wahl alternativer Dotiertechnologien, alternativ zu der bereits eingangs beschriebenen Gasphasendotierung, kann im Regelfall das Problem der Schaffung lokal unterschiedlich dotierter Bereiche auf dem Siliziumsubstrat nicht auflösen. Als Alternativtechnologien seien hier die Deponierung dotierter Gläser, bzw. von amorphen Mischoxiden, mittels PECVD- und APCVD-Verfahren erwähnt. Aus diesen Gläsern kann eine thermisch induzierte Dotierung des sich unter diesen Gläsern befindlichen Siliziums leicht erreicht werden. Zur Schaffung lokal unterschiedlich dotierter Bereiche müssen diese Gläser allerdings mittels Maskenprozessen geätzt werden, um die entsprechenden Strukturen aus diesen heraus zu präparieren. Alternativ hierzu können strukturierte Diffusionsbarrieren vor der Deponierung der Gläser auf den Siliziumwafern abgeschieden werden, um damit die zu dotierenden Bereiche zu definieren. Nachteilig bei diesem Verfahren ist allerdings, dass jeweils nur eine Polarität (n oder p) bei der Dotierung der Substrate erreicht werden kann.

Figur 1 zeigt einen vereinfachenden Querschnitt durch eine IBC-Solarzelle (nicht skaliert, ohne Oberflächentextur, ohne Antireflexions- und Passivierungsschichten, ohne rückseitige Metallisierung). Die alternierenden pn-Übergänge können unterschiedliche Anordnungen aufweisen, wie beispielsweise direkt aneinander angrenzend, oder mit Lücken mit intrinsischen Bereichen).

Konzentrieren wir uns im Folgenden vereinfachend auf einen möglichen Ausschnitt des Herstellungsprozesses einer sogenannten IBC-Solarzelle (Figur 1). Dieser Ausschnitt und damit skizzierte Teilprozess erhebt in dieser Betrachtung nicht den Anspruch auf Vollständigkeit, sowohl als auch nicht auf Ausschließlichkeit. Es sind mühelos Abweichungen und Modifikationen der dargestellten Prozesskette vorstell- als auch realisierbar. Man beginnt mit einem CZ-Wafer, der beispielsweise über eine einseitig alkalisch polierte oder sägeschadensgeätzte Oberfläche verfügt. Dieser Wafer wird auf einer Seite, der nicht polierten und damit der der späteren Vorderseite, mittels eines CVD-Oxides geeigneter Dicke, wie beispielsweise 200 nm oder mehr, vollflächig beschichtet. Nach der einseitigen Beschichtung mit dem CVD-Oxid wird der Wafer einer B-Diffusion in einem konventionellen Rohrofen, mittels beispielsweise Bortribromid als Precursor, unterworfen. Im Anschluss an die Bordiffusion muss der Wafer auf der nun diffundierten Rückseite lokal strukturiert werden, um die Bereiche für die späteren Kontakte zur Basis und zur Herstellung des in diesem Fall mit Phosphor diffundierten lokalen Rückseitenfeldes zu definieren und letztlich zu schaffen. Diese Strukturierung kann beispielsweise mit Hilfe eines Lasers erreicht werden, der das auf der Rückseite vorhandene dotierte Glas lokal ablatiert. Die Verwendung von Laserstrahlung bei der Herstellung von hocheffizienten Solarzellen ist aufgrund der Schädigung des Bulks des Siliziumwafers umstritten. Gehen wir aber der Einfachheit halber davon aus, dass es möglich sei und keine weiteren prinzipiellen Probleme vorlägen oder-liegen. Dann muss im Anschluss an die Laserbehandlung das zumindest an der Oberfläche vorliegende, unstrittig beschädigte Silizium mit Hilfe einer alkalischen Schadensätze entfernt werden. Praktischerweise wird dabei gleichzeitig der an dieser Stelle vorhandene Boremitter mit aufgelöst und entfernt (insofern man ebenfalls in diesem Fall davon ausginge, dass, wie üblicherweise bekannt, mit Bor hoch dotiertes Silizium keinen Ätzstop für auf KOH basierenden Ätzlösungen darstellt) - insofern man berechtigterweise davon ausgehen kann, dass das verbleibende Borosilicatglas (BSG) an den geschlossenen Stellen einen ausreichenden Schutz des Siliziums gegenüber der KOH-Lösung darstellt (Ätzrate von SiO2 in 30 % KOH bei 80 °C beträgt etwa 3 nm/min, geht man bei BSG von einem "gestörten Oxid" aus, dann könnte diese in KOH ggfs. etwas höher sein). In das Silizium wird dabei eine Plateau bzw. eine Art Graben hereingeätzt. Alternativ könnte man die Basiskontakte mit dem späteren lokalen Rückseitenfeld derart schaffen, dass man auf der Rückseite eine Ätzmaske aufträgt, beispielsweise mittels Siebdruckens, und anschließend die offenen Stellen mit Hilfe von zweier konsekutiver oder gar nur eines Ätzschrittes nachbehandelt: einseitige Entfernung des Glases durch Ätzen in Flusssäure und anschließende Ätzung in KOH-Lösung, oder Ätzung beider Materialien in einem Schritt. Im Anschluss würde man entweder die Ätzmaske und das dotierte Glas oder nur das dotierte Glas, beides jeweils einseitig auf der Rückseite entfernen. Daran anknüpfend würde man eine CVD-Oxidschicht auf der Rückseite des Wafers abscheiden, diese lokal Öffnen und strukturieren, und zwar an den Stellen, an welchen zuvor der Boremitter entfernt wurde. Die Wafer würden anschließend einer Phosphordiffusion unterzogen werden. Je nachdem, wie die Prozessparameter dieser Diffusion im Detail aussähen, wären die zuvor beschriebenen Strukturierungen auch nur in einfacher Ausführung erforderlich, und zwar beispielsweise in einem solchen Fall, wenn die Ausführung der Phosphordiffusion das bereits erhaltene Bordotierprofil bei gleichzeitiger Anwesenheit des BSG-Glases nicht mehr, oder eben in kontrollierbarer Weise beeinflussen würde. Anschließend würden die Wafer auf deren Vorderseite einseitig von dem schützenden Oxid befreit und einer schwachen Phosphordiffusion unterzogen werden. Der Einfachheit halber wurde an dieser Stelle davon ausgegangen, dass das auf der Rückseite vorliegende PSG-Glas auf der Waferoberfläche verbleiben könne und somit keine weiteren Störungen bzw. Beeinflussungen hervorrufen würde. Nach der schwachen Diffusion auf der Vorderseite werden die Wafer mit Flusssäure geätzt und alle Oxide und Gläser werden entfernt. In der Summe ist der zuvor skizzierte Prozess von den folgenden Schritten und deren Gesamtanzahl gekennzeichnet (vereinfachend für eine Strukturierung mittels eines Laserprozesses dargestellt; im Fall der Anwendung von Ätzresists würde noch das Drucken und Strippen des Lackes noch hinzugezählt werden müssen):
1. Frontseitige ganzflächige Oxidmaske
2. Bordiffusion
3. Rückseitige Strukturierung und Ätzung
4. Rückseitige ganzflächige Oxidmaske
5. Rückseitige Strukturierung
6. Phosphordiffusion
7. Entfernung frontseitige Oxidmaske
8. Phosphordiffusion
9. Entfernung aller Gläser

In der Summe ergeben sich neun Prozessschritte, um eine strukturierte Dotierung des Wafers zu erzielen. Demgegenüber stünden, je nach Zählweise, acht Prozessschritte zur Herstellung einer ganzen Standard-Aluminium-BSF-Solarzelle. Bei der Herstellung von IBC-Zellen mögen andere Möglichkeiten zur Anwendung kommen können, der Aufwand zum Erzielen der strukturierten Dotierungen ist jedem Fall sehr hoch und ist in jedem dieser Fälle kostenintensiv, bis teilweise derart kostenintensiv wie die Herstellung einer einzigen Standard-Aluminium-BSF-Soalrzelle. Die weitere Verbreiterung dieser Zelltechnologie wird in jedem Fall von der Senkung der Prozesskosten abhängig sein, womit diese von der Etablierung von vereinfachenden, aber dennoch hohen Zelleffizienzen erlaubende, Prozessalternativen deutlich profitieren werden.

Wie aus dieser Darstellung der Herstellung von Solarzellen zu entnehmen ist, wird der gesamte Herstellungsprozess insbesondere von der Vielzahl der Prozessschritte bestimmt, die erfolgen müssen, um strukturierte Dotierungen in dem verwendeten Siliziumsubstrat zu generieren. In diesem Zusammenhang wurden verschiedene flüssige und pastentförmige Medien entwickelt, mit deren Hilfe durch Temperaturbehandlungen entsprechende Dotierungen durchführbar sind und durch die die Zahl der Verfahrensschritte verringert werden kann.

In WO 2014/101990 A1 wird zu diesem Zweck beispielsweise die Herstellung von druckbaren niedrigviskosen Oxidmedien beschrieben, die als p- oder n-dotierend formuliert sein können. Diese Medien können sowohl direkt nebeneinander als auch übereinander auf dem Substrat aufgebracht werden. Sofern unterschiedlich formulierte Medien übereinander aufgebracht werden, erfolgt durch geeignete Wärmebehandlung eine Dotierung aus der direkt auf dem Substrat befindlichen Schicht, während aus darüber befindlichen Schichten eine Dotierung aufgrund ungenügender Diffusionslängen vermieden wird. Auf diese Weise können durch selektiv nacheinander aufgetragene Medien, welche unterschiedliche Dotanden enthalten, nebeneinander liegende Flächen mit unterschiedlicher Dotierung hergestellt werden, wobei jedoch Temperatur und Dauer der Wärmebehandlung, sowie die Reinheit der Ausgangssubstanzen kritische Größen sind, um in strukturierten Bereichen gezielt eine gewünschte Dotierung zu erreichen. Aufeinanderfolgende Wärmebehandlungen, wie sie in WO 2014/101990 A1 beschrieben sind, können sich hierbei negativ auf die strukturierte Dotierung auswirken.

### Aufgabe der vorliegenden Erfindung

Die bei der industriellen Herstellung von Solarzellen üblicherweise verwendeten Technologien zum Dotieren, namentlich durch die gasphasenvermittelte Diffusion mit reaktiven Vorstufen, wie Phosphorylchlorid und/oder Bortribromid, ermöglichen es nicht, gezielt lokale Dotierungen und/oder lokal unterschiedliche Dotierungen auf Siliziumwafern zu erzeugen. Die Schaffung solcher Strukturen ist bei Anwendung bekannter Dotiertechnologien nur durch aufwändige und kostenintensive Strukturierung der Substrate möglich. Bei der Strukturierung müssen verschiedene Maskierungsprozesse aufeinander abgestimmt werden, was die industrielle Massenfertigung solcher Substrate sehr komplex gestaltet. Aus diesem Grund haben sich Konzepte zur Herstellung von Solarzellen, die einer solchen Strukturierung bedürfen, bisher nicht durchsetzen können. Es ist daher Aufgabe der vorliegenden Erfindung ein preiswertes, einfach durchführbares Verfahren, sowie ein in diesem Verfahren einsetzbares Medium zur Verfügung zu stellen, wodurch diese Probleme und die normalerweise erforderliche Maskierungsschritte obsolet sind und damit beseitigt werden. Darüber hinaus zeichnet sich die lokal applizierbare Dotierquelle dadurch aus, dass diese bevorzugt mittels bekannter und in der Technik der Solarzellenfertigung etablierten Drucktechnologien auf die Waferoberflächen aufgebracht werden können. Die Besonderheit der erfindungsgemäßen Verwendung ergibt sich darüber hinaus aus der Tatsache, dass die verwendeten druckbaren Dotiermedien eine diffusionshemmende Wirkung aufweisen gegenüber dem konventionell industriell verwendeten Gasphasendotierstoff Phosphorylchlorid, als auch gegenüber ähnlichen Dotierstoffen, wobei es sich korrekter Weise um Dotierstoffe handeln kann, die infolge ihrer Verbrennung in der Gasphase zu Phosphorpentoxid umgesetzt werden. Somit können in einfachster Weise durch Diffusionen und Dotierungen mit zwei Dotierstoffen entweder simultan oder sequentiell Dotierungen entgegengesetzte Polaritäten in Silizium erfolgen.

### Kurze Beschreibung der Erfindung

Gegenstand der vorliegenden Erfindung ist daher die Verwendung druckbarer Hybridsole und/oder -gele auf Basis von Precursoren, wie des Siliziumdioxids, Aluminiumoxids und Boroxids, welche mittels geeigneter Druckverfahren auf Siliziumoberflächen zum Zwecke der lokalen und/oder ganzflächigen, einseitigen Diffusion und Dotierung bei der Herstellung von Solarzellen, bevorzugt von hocheffizienten strukturiert dotierten Solarzellen, aufgedruckt, angetrocknet und anschließend mittels eines geeigneten Hochtemperaturprozesses zur Abgabe des in dem Hybridgel enthaltenen Boroxidprecursors an das unter dem Hybridgel befindlich Substrat zur gezielten Dotierung des Substrates selbst gebracht werden. Dabei handelt es sich um druckbare Hybridsole und/oder -gele auf Basis von Precursoren der folgenden Oxidmaterialien,
a) Siliziumdioxid: ein- bis vierfach symmetrisch und asymmetrisch substituierte Carboxy-, Alkoxy- und Alkoxyalkylsilane, explizit Alkylalkoxysilane enthaltend, in welchen das zentrale Siliziumatom einen Substitutionsgrad von 1 bis 3 mit mindestens einem direkt an das Siliziumatom gebundene Wasserstoffatom aufweisen kann, wie beispielsweise Triethoxysilan, und wobei sich weiterhin ein Substitutionsgrad auf die Anzahl möglicher vorhandener Carboxy- und/oder Alkoxygruppen bezieht, welche sowohl bei Alkyl- und/oder Alkoxy- und/oder Carboxygruppen einzelne oder verschiedene gesättigte, ungesättigte verzweigte, unverzweigte aliphatische, alicyclische und aromatische Reste aufweisen, die wiederum an beliebiger Position des Alkyl, Alkoxid oder des Carboxyrestes durch Heteroatome, ausgewählt aus der Gruppe O, N, S, Cl und Br funktionalisiert sein können, sowie Mischungen der zuvor genannten Precursoren; einzelne Verbindungen, welche in zuvor genannten Ansprüchen genügen, sind: Tetraethylorthosilicat und dergleichen, Triethoxysilan, Ethoxytrimethylsilan, Dimethyldimethoxysilan, Dimethyldiethoxysilan, Triethoxyvinylsilan, Bis[triethoxysilyl]ethan und Bis[diethoxymethylsilyl]ethan,
b) Aluminiumoxid: symmetrisch und asymmetrisch substituierte Aluminiumalkoholate (-alkoxide), wie Aluminiumtriethanolat, Aluminiumtrisopropylat, Aluminiumtri-sec-butylat, Aluminiumtributylat, Aluminiumtriamylat und Aluminiumtri-iso-pentanolat, Aluminium-tris(-β-diketone), wie Aluminiumacetylacetonat oder Aluminium-tris(1, 3-cyclohexandionate), Aluminium-tris(-β-ketoester), Aluminiummonoacetylacetonat-monoalkoholat, Aluminium-tris-(hydroxychinolate), Aluminiumseifen, wie mono- und dibasisches Aluminiumstearat und Aluminiumtristearat, Aluminiumcarboxylate, wie basisches Aluminiumacetat, Aluminiumtriacetat, basisches Aluminiumformat, Aluminiumtriformat und Aluminiumtrioctoat, Aluminiumhydroxid, Aluminiummetahydroxid und Aluminiumtrichlorid und dergleichen, sowie deren Mischungen,
c) Boroxid: Diboroxid, einfache Borsäurealkylester, wie Triethylborat, Trisopropylborat, Borsäureester aus funktionalisierten 1,2-Glykolen, wie beispielsweise Ethylenglykol, funktionalisierten 1,2,3-Triolen, wie beispielsweise Glycerin, funktionalisierten 1,3-Glykolen, wie beispielsweise, 1,3- Propandiol, Borsäureestern mit Borsäureestern, die zuvor genannte Strukturmotive als strukturelle Untereinheiten enthalten, wie beispielsweise 2,3-Dihydroxbernsteinsäure und deren Enantiomere, Borsäureestern, aus Ethanolamin, Diethanolamin, Triethanolamin, Propanolamin, Dipropanolamin und Tripropanolamin, gemischten Anhydriden aus Borsäure und Carbonsäuren, wie beispielsweise Tetracetoxydiborat, Borsäure, Metaborsäure, und Mischungen zuvor genannter Precusoren,
welche unter wasserhaltigen oder wasserfreien Bedingungen mit Hilfe der Sol-Gel-Technik entweder simultan oder sequentiell zu partieller oder vollständiger intra- und/oder interspeziärer Kondensation gebracht werden, wobei sich infolge der eingestellten Kondensationsbedingungen, wie Precursor-Konzentrationen, Wassergehalt, Katalysatorgehalt, Reaktionstemperatur und -zeit, der Zugabe von kondensationskontrollierenden Agentien, wie beispielsweise verschiedener oben genannter Komplex- und Chelatbildner, verschiedener Lösungsmittel und deren individuellen Volumenfraktionen, und durch gezieltes Eliminieren leichtflüchtiger Reaktionshilfsmittel und unvorteilhafter -nebenprodukte, der Gelierungsgrad der entstehenden Hybridsole und -gele gezielt gesteuert und in erwünschter Weise beeinflusst wird, sodass lagerungsstabile, sehr gut druckbare und druckstabile Formulierungen erhalten werden.

Die so erhaltenen druckbaren Hybridsole und/oder-gele, wie im Folgenden näher beschrieben, lassen sich sehr gut auf Oberflächen von Siliziumwafern verdrucken. Sie können mittels geeigneter Druckverfahren, wie Schleuder- oder Tauch-Beschichtung, Drop-Casting, Curtain- oder Schlitzdüsen-Coating, Screen- oder Flexodrucken, Gravur-, Ink Jet- oder Aerosol Jet-Drucken, Offset-Drucken, Micro Contact-Drucken, elektrohydrodynamischer Dispensen, Walzen- oder Sprüh-Beschichtung, Ultraschall-Sprüh-Beschichtung, Pipe Jet-Drucken, Laser Transfer-Drucken, Tampondruck, Flachbettsiebdruck und Rotationssiebdruck verarbeitet und auf entsprechende Oberflächen deponiert werden. Entsprechende druckbare Hybridsole und/oder -gele sind besonders gut geeignet zur Verwendung als Dotiermedien zur Bearbeitung von Siliziumwafern für photovoltaische, mikroelektronische, mikromechanische und mikrooptische Applikationen. Insbesondere zeigen diese Zusammensetzungen vorteilhafte Eigenschaften für die Herstellung von PERC-, PERL-, PERT-, IBC-Solarzellen und weiterer Solarzellen, wobei die Solarzellen weitere Architekturmerkmale, wie MWT, EWT, Selektiver Emitter, Selektives Front Surface Field, Selektives Back Surface Field und Bifacialität aufweisen.

Bei den erfindungsgemäßen druckbaren Hybridsolen und/oder -gelen handelt es sich um borhaltige Dotiermedien für Siliziumoberflächen, die während der Bordotierung gleichzeitig als Diffusionsbarriere oder als diffusionshemmende Schicht gegenüber unerwünschtem Eindiffundieren von Phosphor durch diese Medien selbst wirken und eine entsprechende Diffusion vollständig blockieren oder in ausreichendem Maß hemmen, so dass die unter diesen aufgedruckten Medien vorherrschende Dotierung p-Typ, also borhaltig, ist.

Die oben beschriebene Aufgabe wird dementsprechend durch das Zurverfügungstellen der beschriebenen druckbaren Hybridsole und/oder -gele, insbesondere aber auch durch deren Verwendung in der Solarzellenherstellung zur Bordotierung gelöst, wobei gleichzeitig die Dotierung derselben Flächen durch Phosphor vermieden wird. Die entsprechende Verwendung ist dadurch gekennzeichnet, dass durch geeignete Temperaturbehandlung eine Dotierung des bedruckten Substrates simultan erfolgt und eine Dotierung der unbedruckten Siliziumwaferoberflächen mit Dotanden der entgegengesetzten Polarität mittels konventioneller Gasphasendiffusion induziert wird und wobei die aufgedruckten Hybridsole und/oder -gele gegenüber den Dotanden der entgegengesetzten Polarität als Diffusionsbarriere wirkt. Insbesondere umfasst das erfindungsgemäße Verfahren die Schritte, dass
a. Siliziumwafer mit den Hybridsolen und/oder -gelen lokal ein- oder beidseitig oder einseitig ganzflächig bedruckt werden, die aufgedruckten Zusammensetzungen angetrocknet und verdichtet werden gleichzeitig einer Gasphasendiffusion mit beispielsweise Phosphorylchlorid ausgesetzt werden, wodurch p-Typ Dotierungen in den bedruckten Bereichen und n-Typ Dotierungen in den Bereichen erhalten werden, die ausschließlich der Gasphasendiffusion ausgesetzt sind,
   oder
b. auf dem Siliziumwafer großflächig deponiertes Hybridsol und/oder -gel verdichtet wird und aus der getrockneten und/oder verdichteten Paste mit Hilfe von Laserbestrahlung, die lokale Dotierung des darunter liegenden Substratmaterials initiiert wird, gefolgt von einer Hochtemperaturdiffusion und -dotierung zur Herstellung von zweistufigen p-Typ Dotierniveaus im Silizium induziert wird,
   oder
c. der Siliziumwafer lokal einseitig mit Hybridsolen und/oder -gelen bedruckt wird, wobei die strukturierte Deponierung gegebenenfalls alternierende Linien aufweisen kann, die gedruckten Strukturen angetrocknet und verdichtet werden, und der Siliziumwafer nachträglich auf der gleichen Waferseite ganzflächig mit Hilfe von PVD- und/oder CVD-deponierten phospordotierend wirkenden Dotierstoffquellen beschichtet wird, wobei die gedruckten Strukturen der Hybridsole und - gele verkapselt werden, und die überlappende Gesamtstruktur durch geeignete Hochtemperaturbehandlung zur strukturierten Dotierung des Siliziumwafers gebracht wird und wobei das aufgedruckte Hybridgel gegenüber der darüber befindlichen phosphorhaltigen Dotierstoffquelle und des darin enthaltenen Dotierstoffs als Diffusionsbarriere wirkt,
   oder
d. der Siliziumwafer lokal einseitig mit Hybridsolen und/oder -gelen bedruckt wird, wobei die strukturierte Deponierung gegebenenfalls alternierende Linien aufweisen kann, die gedruckten Strukturen angetrocknet und verdichtet werden, und der Siliziumwafer nachträglich auf der gleichen Waferseite ganzflächig mit Hilfe von phosphordotierend wirkenden Dotiertinten oder Dotierpasten beschichtet wird, wobei die gedruckten Strukturen der Hybridsole und - gele verkapselt werden, und die überlappende Gesamtstruktur durch geeignete Hochtemperaturbehandlung zur strukturierten Dotierung des Siliziumwafers gebracht wird, wobei das aufgedruckte Hybridgel gegenüber der darüber befindlichen phosphorhaltigen Dotierstoffquelle und des darin enthaltenen Dotierstoffs als Diffusionsbarriere wirkt.

### Detaillierte Beschreibung der Erfindung

Überraschenderweise wurde gefunden, dass druckbare Hybridsole und Hybridgele, die mindestens aus folgenden Oxidprecursoren bestehen, Aluminiumoxid, Siliziumdioxid und Boroxid, sich als druckbare Dotiermedien zur lokalen Dotierung von Siliziumwafern eignen und gleichzeitig die Diffusion derselben, mit diesen Hybridsolen und -gelen bedruckten, Wafer, mit Bor zulassen, wobei die gedruckten Hybridsole und -gele gegenüber der Diffusion mit Phosphor als effiziente Diffusionsbarriere wirken. Anders ausgedrückt: man erhält unter den geschilderten Co-Diffusionbedingungen in den Bereichen die mit den erfindungsgemäßen Solen und Gelen bedruckt werden eine ausschließliche Dotierung mit Bor, und in den Bereichen, die dem dotierend wirkenden Phosphoroxiddampf ausgesetzte werden, eine ausschließliche Dotierung mit Phosphor. Die erfindungsgemäßen Hybridsole und -gele sind in den folgenden Dokumenten beschrieben WO 2012/119686 A, WO2012119685 A1, WO2012119684 A, EP12703458.5 und EP12704232.3,.

Die Anwendung der erfindungsgemäßen Hybridsole und -gele ermöglicht somit eine vereinfachende Herstellung von entweder Solarzellen, die über strukturierte Dotierungen verfügen, wie beispielsweise IBC-Zellen, oder ganz allgemein von solchen Zellen, die über mindestens zwei unterschiedliche, nicht notwendigerweise entgegengesetzte, Dotierungen verfügen. Im Folgenden werden mögliche Anwendungen der erfindungsgemäßen Dotiermedien skizzierend dargestellt.

Figur 2 zeigt einen vereinfachten Prozessfluss zur Herstellung einer bifacialen (in diesem Fall n-Typ) Solarzelle (PERT-Struktur). Als Dotierstoffquelle für die Phosphordiffusion wurde eine Phosphorpaste angenommen, es kann sich aber genauso gut um jede andere ganzflächig abgeschiedene Quelle, wie beispielsweise eine Dotiertinte oder ein CVD-Glas, eine aufgesputterte Schicht, epitaktisch abgeschiedenes phosphordotiertes Silizium, oder eine mit Phosphor angereicherte Siliziumnitridschicht handeln. Anstelle der in der Figur genannten erfindungsgemäßen Borpaste kann natürlich auch eine erfindungsgemäße Bordotiertinte zum Einsatz kommen.

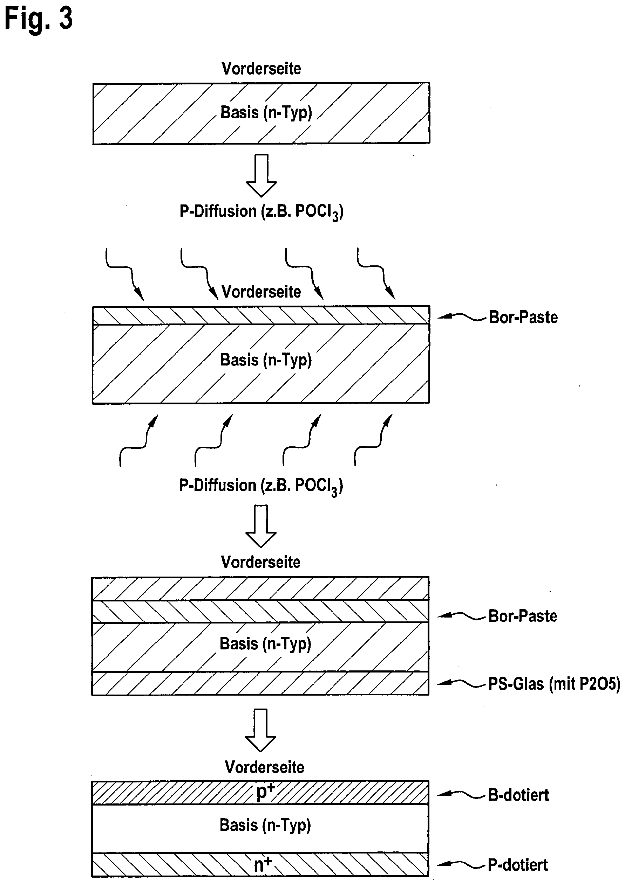

Die Herstellung einer bifacial Zelle gemäß der Figur 2 umfasst die folgenden wesentlichen Prozessschritte: zwei Druckschritte zum Bedrucken der Waferoberfläche, Eintreiben der Dotanden, Entfernen des Glases. In der Summe 4 Prozessschritte, denen bei Anwendung des klassischen Gasphasendiffusionsverfahrens mindestens sechs gegenüberständen, davon zwei Hochtemperaturschritte: einseitige Maskierung, Diffusion mit B, Entfernung der Oxide, Maskierung der bereits dotierten Oberfläche, Diffusion mit P, Entfernung der Oxide. Die Verwendung der erfindungsgemäßen borhaltigen Dotiermedien schafft gegenüber der klassischen Prozessvariante eine nominelle Reduktion der notwendigen Prozessschritte von einem Drittel, was sich damit in günstigere Herstellkosten übersetzen lässt. Die oben gezeigte bifaciale Zelle lässt sich auch durch die Anwendung von anderen einseitig deponierbaren Dotierquellen, wie beispielsweise phosphorhaltige Dotiertinten oder ein CVD-Glas, eine aufgesputterte Schicht, epitaktisch abgeschiedenes und phosphordotiertes Silizium, oder eine mit Phosphor angereicherte Siliziumnitridschicht, herstellen; wobei in diesem Zusammenhang natürlich auch die umgekehrte Vorgehensweise prinzipiell vorstellbar ist. Bei Verwendung der zuvor genannten einseitig wirkenden Dotierstoffquellen ist ebenfalls eine Verkürzung der Prozesssequenz zu erhalten: Deposition der Quelle 1, Deposition der Quelle 2, Diffusion, Entfernung der Rückstände. Insofern beide Quellen mit einem Ätzschritt zu beseitigen sind, ergibt sich der nominell gleiche Aufwand, wie in dem bereits zuvor erläuterten Fall: vier Prozessschritte. Das gilt selbst für den Fall, wenn die erfindungsgemäße Bordotierquelle, Tinte (Hybridsol) oder Paste (Hybridgel), durch eine der zuvor genannten Quellen, wie beispielsweise ein CVD-Glas ersetzt werden würde. Nun ist allerdings die Abscheidung von CVD-Glas als Vakuumprozess aufgrund der Vakuumbedingungen ein recht kostenintensiver Prozessschritt. Nämliches gilt auch für das Sputtern oder epitaktische Abscheiden, sodass der Verwendung der erfindungsgemäßen Bordotiermedien aufgrund der kostengünstigeren Deponierbarkeit mittels Druckschritten ein inhärenter Kostenvorteil gegenüber steht. Im Prinzip stellt die beidseitig mit Dotiermedien bedruckte Waferoberfläche die kostengünstigste Möglichkeit dar. Gemäß der erfindungsgemäßen Komposition der borhaltigen Hybridsole und -gele stellen auch parasitäre häufig aus phosphorhaltigen Dotiermedien stattfindende und zu beobachtende Dotierungen keine signifikanten Einschränkung der Möglichkeit zur Herstellung einer bifacialen Solarzelle auf diesem Wege dar: die erfindungsgemäßen borhaltigen Hybridsole und -gele wirken, neben ihrer Funktion als Dotierstoffquelle, als Diffusionsbarrieren für Phosphordiffusionen. Überraschenderweise wurde deshalb festgestellt, dass mit Hilfe der erfindungsgemäßen Hybridsole und -gele bifaciale Solarzellen gemäß des in der Figur 3 skizzierten Schemas in einfacher Weise hergestellt werden können.

Figur 3 zeigt einen vereinfachten Prozessfluss zur Herstellung einer bifacialen (in diesem Fall n-Typ) Solarzelle (PERT-Struktur). Dargestellt ist ein Co-Diffusionsprozess unter Anwendung einer klassischen Diffusion mit Phosphorylchlorid. Die erfindungsgemäßen Hybridsole und -gele (hier nur erwähnt als Borpaste) wirken, neben ihrer Funktion als Dotierstoffquelle, als Diffusionsbarriere gegenüber der Phosphordiffusion.

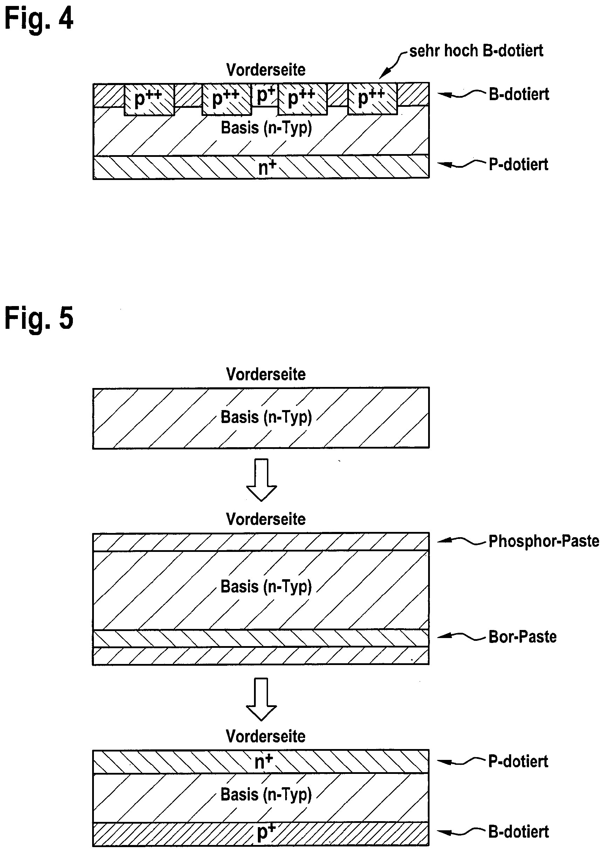

Die erfindungsgemäßen Hybridsole und -gele wirken als Diffusionsbarriere gegenüber einer Phosphordiffusion und schützen damit den Siliziumwafer vor dem Eindringen dieses Dotierstoffes aus der Gasphase in die Oberflächenregionen des Wafers. Gleichzeitig bleibt die bor-dotierende Wirkung der erfindungsgemäßen Hybridsole und -gele erhalten und ermöglicht somit einerseits den Schutz vor dem Eindringen von Phosphor in den Halbleiter und andererseits die wirkungsvolle Diffusion und Dotierung der mit diesen Medien bedruckten Oberflächen mit der erwünschten und beabsichtigten Bordotierung. Die Ausführung der Herstellung einer bifacialen Solarzelle nach dem oben skizzierten Prinzip führt zu den folgenden wesentlichen Prozessschritten: Drucken der Borquelle, Co-Diffusion mit einer Phosphorquelle aus der Gasphase, Entfernen der Oxide und Gläser - in der Summe drei Prozessschritte. Das entspricht somit einer Reduktion der notwendigen Prozessschritte zu Herstellung einer bifacialen Solarzelle um die Hälfte gegenüber der klassischen Vorgehensweise (Gasphasendiffusion mit Maskierungen), sowie einer Reduktion von einem Viertel der notwendigen Prozessschritte gegenüber dem zuvor skizzierten Fall unter der Anwendung von beispielsweise CVD-basierten oder ähnlichen Dotierstoffquellen. Die Co-Diffusion mit den erfindungsgemäßen borhaltigen Hybridsolen und -gelen als Dotierstoffquellen stellt damit die kostengünstigste Möglichkeit zur Herstellung von bifacialen Solarzellen dar. Es versteht sich in diesem Zusammenhang von selbst, dass unter Einbeziehung der europäischen Patentanmeldungen 14004453.8 und14004454.6 auch sehr einfach selektiv dotierte Strukturen, mindestens in den mit Bor zu dotierenden Regionen, des Wafers hergestellt werden können (vgl. Figur 4).

Figur 4 zeigt eine vereinfachte schematische Darstellung einer bifacialen Solarzelle (n-Typ) mit selektiver oder zweistufiger Dotierung (selektiver Boremitter) im Bereich des Boremitters.

Die folgenden Figuren skizzieren die bereits für die bifacialen n-Typ Solarzellen geschilderten Prozesssequenzen. Die Figuren 5 bis 7 zeigen die möglichen Prozesssequenzen und deren Ergebnisse für p-Typ Wafer als Basismaterial. Die für diese Prozesssequenzen grundsätzlich ableitbaren Aussagen sind die gleichen, wie bereits für den Fall der Herstellung von bifacialen n-Typ-Zellen ausgeführt.

Figur 5 zeigt einen vereinfachten Prozessfluss zur Herstellung einer möglichen bifacialen (in diesem Fall p-Typ) Solarzelle (PERT-Struktur). Als Dotierstoffquelle für die Phosphordiffusion wurde eine Phosphorpaste angenommen.Es kann sich aber genauso gut um jede andere ganzflächig abgeschiedene Quelle, wie beispielsweise eine Dotiertinte oder ein CVD-Glas, eine aufgesputterte Schicht, epitaktisch abgeschiedenes phosphordotiertes Silizium, oder eine mit Phosphor angereicherte Siliziumnitridschicht handeln. Anstelle der in der Figur genannten erfindungsgemäßen Borpaste kann natürlich auch eine erfindungsgemäße Bordotiertinte zum Einsatz kommen.

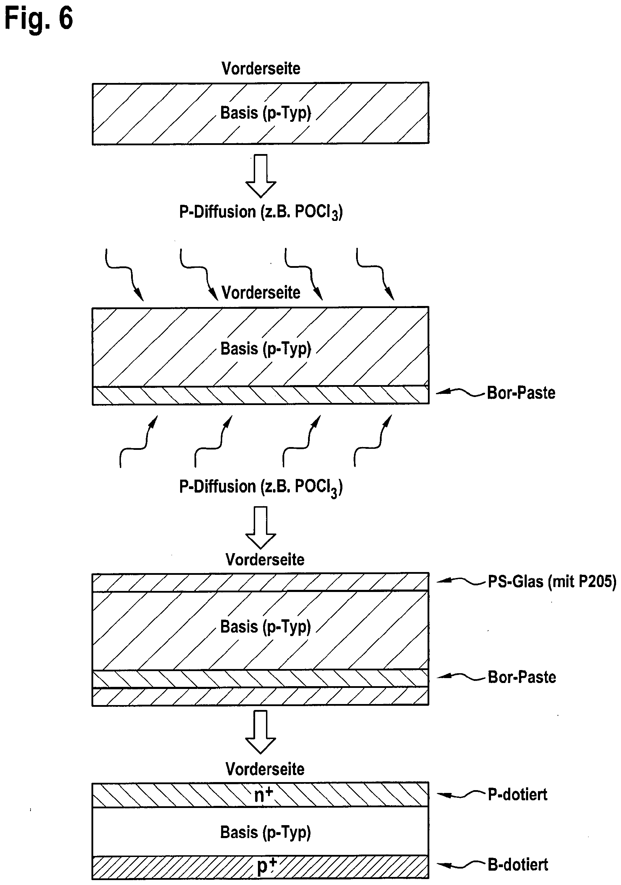

Figur 6 zeigt einen vereinfachten Prozessfluss zur Herstellung einer möglichen bifacialen (in diesem Fall p-Typ) Solarzelle (PERT-Struktur). Dargestellt ist ein Co-Diffusionsprozess unter Anwendung einer klassischen Diffusion mit Phosphorylchlorid. Die erfindungsgemäßen Hybridsole und -gele (hier nur erwähnt als Borpaste) wirken, neben ihrer Funktion als Dotierstoffquelle, als Diffusionsbarriere gegenüber der Phosphordiffusion.

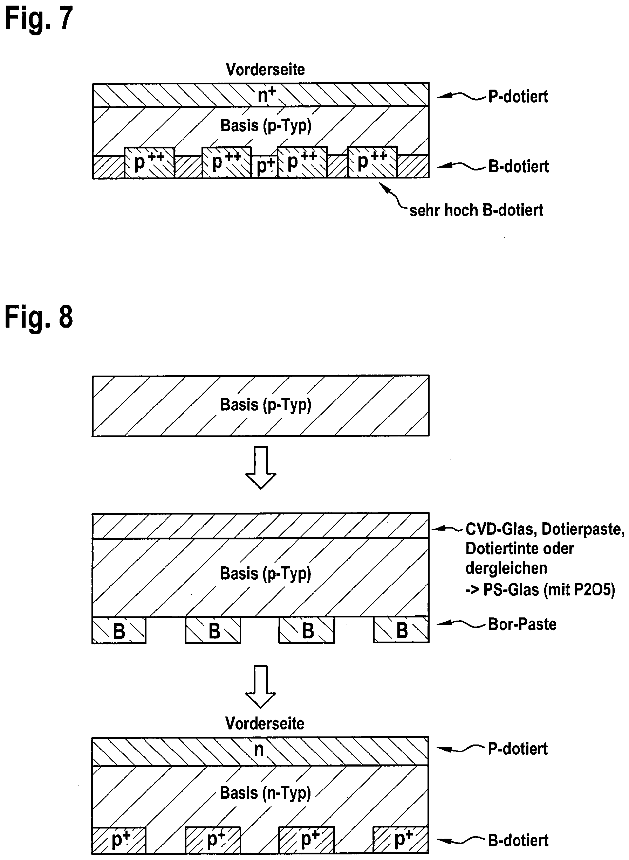

Figur 7 zeigt eine vereinfachte schematische Darstellung einer möglichen bifacialen Solarzelle (p-Typ) mit selektiver oder zweistufiger Dotierung (selektives Rückseitenfeld) im Bereich des Bor-Rückseitenfeldes.

In Figur 8 wird eine mögliche Prozesssequenz für die Herstellung einer p-Typ PERL-Solarzelle gezeigt. Die in dem Schema skizzierte Darstellung basiert auf der Verwendung von ganzflächig und strukturiert deponierbaren Dotierstoffquellen. Im Falle der Anwendung einer klassischen Gasphasendiffsuion, wie beispielsweise infolge der Anwendung von Phosphorylchlorid zur Phosphordiffusion, wäre noch ein zusätzlicher Maskenschritt zum Schutz der rückseitigen, offenen und basisdotierten Bereiche des Wafers notwendig.

Figur 8 zeigt eine vereinfachte schematische Darstellung eines möglichen Herstellungsprozesses einer p-Typ-Solarzelle mit rückseitigen lokalen Kontakten (PERL-Struktur). Als Dotierstoffquelle für die Phosphordiffusion wurden eine Phosphorpaste, Phosphortinte oder ein CVD-Glas angenommen. Es kann sich aber genauso gut um jede andere ganzflächig abgeschiedene Quelle, wie beispielsweise eine aufgesputterte Schicht, epitaktisch abgeschiedenes phosphordotiertes Silizium, oder eine mit Phosphor angereicherte Siliziumnitridschicht handeln. Anstelle der in der Figur genannten erfindungsgemäßen Borpaste kann natürlich auch eine erfindungsgemäße Bordotiertinte zum Einsatz kommen.

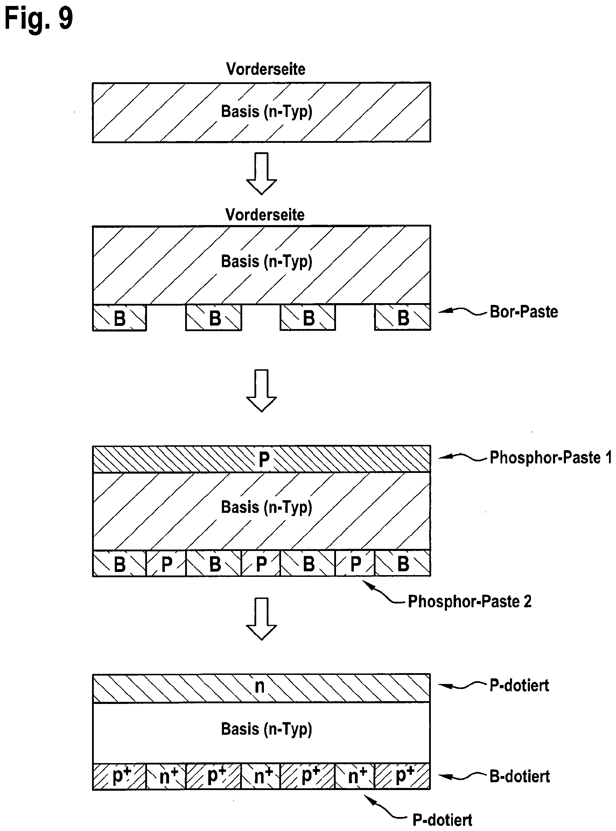

Wenden wir uns nun der Herstellung einer IBC-Solarzelle zu. Mit der klassischen Vorgehensweise, basierend auf der Gasphasendiffusion, haben wir gesehen, dass eine Sequenz bestehend aus neun Prozessschritten zum Erreichen der strukturierten Dotierbereiche notwendig ist. In der Figur 9 ist eine alternative Vorgehensweise dargestellt, die auf der Verwendung von auf der Rückseite strukturiert aufzubringenden Dotiermedien, wie den erfindungsgemäßen Hybridsolen und -gelen basiert, während auf der Vorderseite des Wafers eine weitere Dotierquelle ganzflächig aufgebracht werden kann. Bei der Dotierquelle auf der Vorderseite kann es sich ebenfalls um ein erfindungsgemäßes Dotiermedium, Hybridsol und/oder Hybridgel, handeln, muss es sich jedoch nicht notwendigerweise. Ebenso sind die bereits erwähnten alternativen Dotierstoffquellen, wie beispielsweise ein CVD-Glas, geeignet. Zuvor Genanntes gilt selbstredend auch für die Rückseite. Betrachtet man sich die Herstellungsweise basierend auf den erfindungsgemäßen Hybridsolen und -gelen, dann sind fünf Prozessschritte zur Erzielung einer strukturierten Dotierung notwendig: Deponierung Quelle 1, Deponierung Quelle 2, Deponierung 3, Hochtemperatur Co-Diffusion aller Quellen in einem konventionellen Rohrofen, Entfernung der Dotierstoffquellen. Das entspricht somit einer nominellen Reduktion der benötigen Prozessschritte um 45 % gegenüber der Verwendung des klassischen Diffusionsprozesses, was sich somit in deutlichen Kostenvorteilen des Prozesses auswirkt. Das gleiche Ergebnis wird bei der Anwendung von beispielsweise der ganzflächigen frontseitigen Abscheidung von CVD-Gläsern als Dotierstoffquelle erhalten. Da die Verwendung der bisherigen Dotierstoffquelle eine Deponierung per Vakuumprozess voraussetzt, sind die erzielbaren Kosteneinsparungen nicht von der gleichen Größenordnung, wie sie im Falle der Verwendung von den druckbaren erfindungsgemäßen Hybridsolen und -gelen als Dotierstoffquelle erhalten werden. Wendet man die dotierend wirkenden CVD-Gläser auch für die Definition der auf der Rückseite vorhanden dotierten Bereiche an, dann ergibt sich aufgrund der erforderlichen Maskierungs- und Strukturierungsverfahren ein Mehraufwand von mindestens einem Strukturierungs- und Ätzschritt (zuvor als eine Einheit gezählt); sofern man auf die Abscheidung einer weiteren Capping-Schicht, die zwei aufeinander abgeschiedene dotierte CVD-Gläser voneinander trennt, verzichten kann. Gegenüber der Vorgehensweise basierend auf der Gasphasendiffusion würde somit ein Reduktion der notwendigen Prozessschritte um ein Drittel erreicht werden, gegenüber der Verwendung der erfindungsgemäßen dotierend wirkenden Hybridsole und -gele ergäbe sich hingegen ein Mehraufwand von einem weiteren zusätzlichen Prozessschritt oder von einem Fünftel. Es versteht sich von selbst, dass eine Prozessfolge, basierend auf dem Verdrucken der erfindungsgemäßen Hybridsole und -gele, den anderen skizzierten Prozessabfolgen aus Kostengesichtspunkten vorzuziehen ist.

Figur 9 zeigt eine vereinfachte schematische Darstellung eines möglichen Herstellungsprozesses einer n-Typ IBC-Solarzelle. Als Dotierstoffquelle für die vorderseitige Phosphordiffusion wurden eine Phosphorpaste, Phosphortinte oder ein CVD-Glas angenommen. Es kann sich aber genauso gut um jede andere ganzflächig abgeschiedene Quelle, wie beispielsweise eine aufgesputterte Schicht, epitaktisch abgeschiedenes phosphordotiertes Silizium, oder eine mit Phosphor angereicherte Siliziumnitridschicht handeln. Auf der Rückseite wird die strukturierte Diffusion mit Hilfe von unterschiedlichen Dotiermedien, in diesem Falle als Bor- und Phosphorpaste bezeichnet, erhalten. Anstelle der in der Figur genannten erfindungsgemäßen Borpaste kann natürlich ganz zwanglos eine erfindungsgemäße Bordotiertinte verwendet werden.

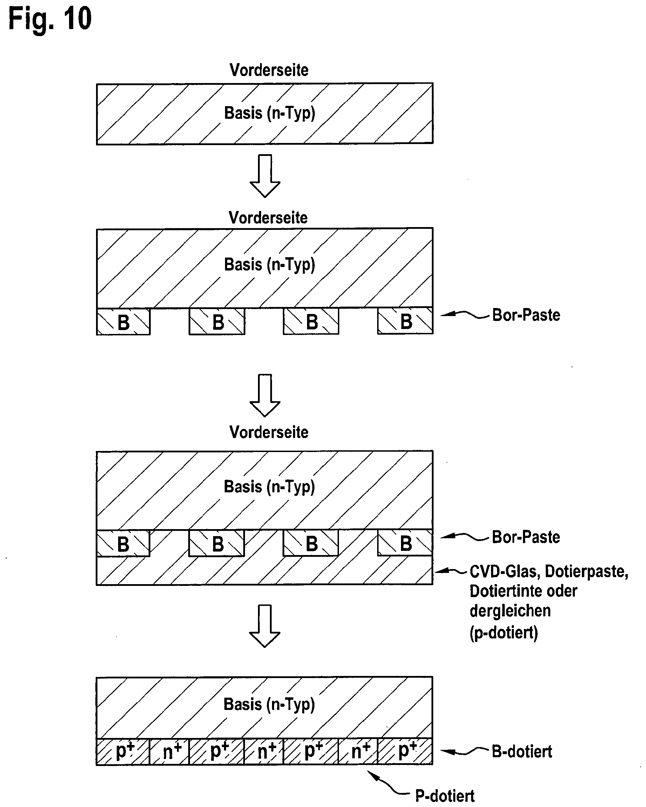

Eine weitere Vereinfachung der Herstellung von IBC-Solarzellen ergibt sich aus dem in der Figur 10 schematisch dargestelltem Prozessfluss. Bei diesem Prozessfluss wird die Eigenschaft der erfindungsgemäßen Hybridsole und - gele, als Diffusionsbarriere für eine Phosphordiffusion zu wirken, konsequent ausgenutzt. Infolgedessen ergeben sich wie im zuvor genannten Beispiel fünf Prozessschritte, um eine strukturierte Dotierung für IBC-Zellen zu erzielen (in diesem Fall inkl. der in der Figur nicht dargestellten Frontseitendotierung): Deponierung Quelle 01, Deponierung Quelle 2, Deponierung Quelle 3, Hochtemperatur Co-Diffusion aller Dotierquellen, Entfernung der Dotierstoffquellen. In diesem Beispiel kann eine weitere Kostenreduktion gegenüber dem zuvor skizzierten Beispiel erreicht werden, indem die rückseitige Phosphorquelle beispielsweise als Dotiertinte mit einem sehr durchsatzstarken Depositionsschritt abgeschieden wird. Solch ein Schritt stellt beispielsweise die Sprühbeschichtung der ganzen Waferoberfläche dar. Alternativ mag es sich auch um einen Flexodruckschritt handeln, welcher einen bis zu 2.5- bis 3.0-fachen Waferdurchsatz gegenüber einer konventionellen Siebdrucklinie haben soll. Wird die erfindungsgemäße borhaltige Dotierquelle ebenso auf der Waferoberfläche deponiert, sind auch gegenüber einer recht kostengünstigen Siebdruckverarbeitung noch weitere Kostensenkungspotentiale auszuschöpfen.

Figur 10 zeigt eine vereinfachte schematische Darstellung eines möglichen Herstellungsprozesses einer n-Typ IBC-Solarzelle. Die Diffusion der Vorderseite wurde in diesem Fall außer Betracht gelassen. Auf der Rückseite wird die strukturierte Diffusion mit Hilfe von unterschiedlichen Dotiermedien, in diesem Falle dem strukturierten Auftrag der erfindungsgemäßen Borpaste, wobei es sich im Prinzip genauso gut um eine erfindungsgemäße Bortinte handeln, erzielt. Die Rückseite des Wafers wird anschließend mit einer weiteren phosphorhaltigen Dotierstoffquelle ganzflächig beschichtet, wobei das erfindungsgemäße, aufgedruckte borhaltige Dotiermedium ebenfalls von der phosphorhaltigen Quelle bedeckt wird. Im Bereich, der nicht mit dem erfindungsgemäßen dotierend wirkenden borhaltigen Medium bedeckt ist, liegt die phosphorhaltige Quelle direkt auf der Waferoberfläche auf und kann diese während eines Hochtemperaturprozesses entsprechend mit Phosphor dotieren, wohingegen in den Bereichen des erfindungsgemäßen borhaltigen Dotiermediums dieses gegenüber der Phosphordiffusion als Diffusionsbarriere wirkt und somit die Waferoberfläche vor dem Eindringen des Phosphors schützt, aber gleichzeitig in der Lage ist, den in dem Medium enthaltenen Dotierstoff, in diesem Fall Bor, an den Wafer abzugeben und damit dessen Dotierung mit Bor zu induzieren. Es entstehen strukturierte pn-Übergänge mit alternierender Abfolge der unterschiedlichen Dotierregimes. Das in der Figur erwähnte CVD-Dotierglas kann hierbei zwanglos durch alternative Dotierstoffquellen, wie beispielsweise eine Dotiertinte, eine aufgesputterte Schicht, epitaktisch abgeschiedenes phosphordotiertes Silizium, oder eine mit Phosphor angereicherte Siliziumnitridschicht ersetzt werden.

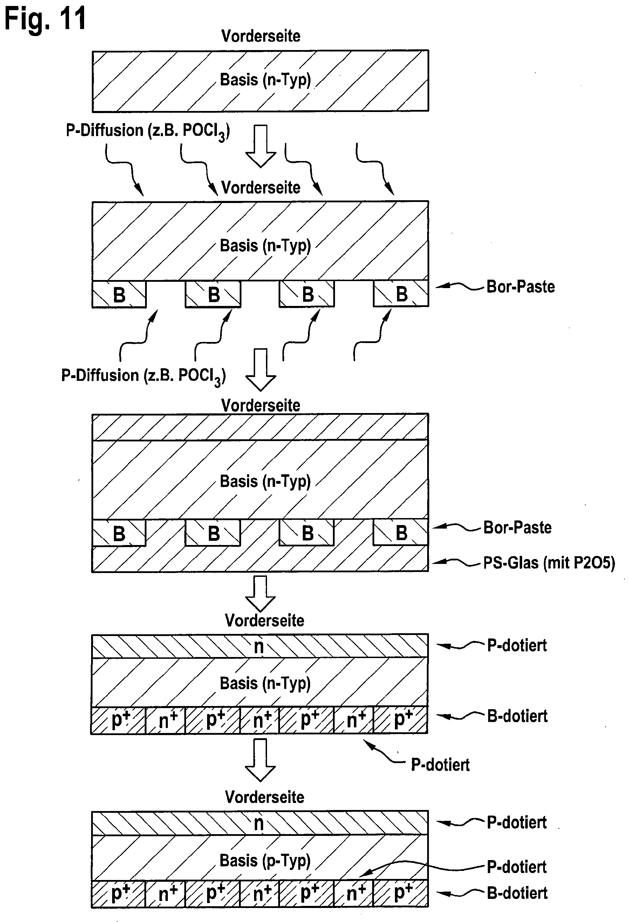

Durch konsequentes Ausnutzen der Diffusionsbarriere-Eigenschaften der erfindungsgemäßen Hybridsole und -gele gegenüber einer Phosphordiffusion kann die Herstellung einer IBC-Solarzelle weiterhin vereinfacht werden. Bei dieser Vereinfachung bedient man sich eines Co-Diffusionsschrittes zur Erhaltung einer Bordotierung bei gleichzeitiger erfolgender Diffusion mit Phosphor aufgrund der beispielsweisen thermischen Zersetzung von Phosphorylchlorid. Beide Merkmale werden in einem einzigen Prozessschritt in einem konventionellen Rohrofenprozess durchgeführt. Anschließend wird der Wafer auf der Vorderseite mittels einseitigen Ätzens derart behandelt, dass die frontseitige Dotierung auf bestimmtes, erwünschtes Maß des Schichtwiderstandes eingestellt wird (vgl. Figur 11). Letzteres ist notwendig, weil IBC-Solarzellen auf der Vorderseite in der Regel eine schwächere Dotierung als an den rückseitigen Kontaktstellen, dem lokalen Rückseitenfeld aufweisen. Die geringere Dotierung auf der Frontseite fördert die Passivierbarkeit dieser Oberfläche, was eine Reduktion der Dunkelstromsättigungsdichte und somit einen Anstieg der Zellspannung mit sich bringt. Letzteres äußerst sich letztlich in einer Effizienzzunahme bzw. als einer der wichtigsten Hebel, die Effizienz einer Solarzelle, in diesem Fall, positiv zu beeinflussen. Als Konsequenz ergibt sich als Prozesskette zum Erhalt strukturierter Dotierungen die folgende Anzahl von Schritten: Deponierung der Borquelle, Hochtemperaturdiffusion in Anwesenheit eines reaktiven Phosphor-Precursors, Rückätzen der frontseitigen Dotierung und Entfernen der Dotierstoffquellen. Zusammengefasst handelt es sich hierbei um vier Prozessschritte. Fassen wir nun das Ätzen des Frontseitenfeldes und die Entfernung des Glases als einen Prozessschritt zusammen, was man insofern als gerechtfertigt erachten könnte, weil bei der Auflistung der notwendigen Prozessschritte im Zuge der klassischen Vorgehensweise zum Erhalt strukturierter Dotierung diese Praxis ebenfalls angewandt wurde (vgl. Strukturierung und Ätzung), viel ausschlaggebender jedoch noch, weil diese Prozesssequenz in der industriellen Fertigung bereits dergestalt zur Herstellung von selektiven Emitter-Solarzellen etabliert war oder zum Teil noch ist, dann ergeben sich insgesamt drei Prozessschritte. Als Konsequenz eröffnet somit die Herstellung von IBC-Solarzellen mit Hilfe der erfindungsgemäßen Hybridsole und -gele die Möglichkeit, gegenüber der klassischen, rein Gasphasen vermittelten Dotierung sechs Prozessschritte bzw. zwei Drittel des notwendigen Aufwandes einzusparen. Prinzipiell lässt sich die gleiche Prozesskette auch mit alternativen herkömmlichen PVD- oder CVD-deponierten Dotierstoffquellen realisieren. Diese müssen jedoch nach deren Abscheidung auf der Rückseite strukturiert werden, um Bereiche zu definieren, die mittels des Gasphasenprozesses dotiert werden sollen - in diesem Fall praktischerweise ebenso mit Hilfe einer Phosphordiffusion mit Phosphorylchlorid. Die sich hieraus ergebende Prozesskette weist somit notwendigerweise vier Prozessschritte auf. Des Weiteren muss im Regelfall eine Capping-Schicht mit eingebunden werden, um die Durchdringung des in diesem Fall aufgebrachten BSG-Glases durch die Phosphordiffusion mit diffundierendem Phosphor zu unterbinden. Somit wird offensichtlich, dass die Anwendung der erfindungsgemäßen Hybridsole und -gele, die dotierend wirken, und als Barriere gegenüber Phosphor wirkend einen immanenten Vorteil aufweisen, der zur kosteneffizienten Herstellung von IBC-Solarzellen signifikanten beitragen kann.

Figur 11 zeigt eine vereinfachte schematische Darstellung eines möglichen Herstellungsprozesses einer n-Typ IBC-Solarzelle. Die Diffusion der Vorderseite wurde in diesem Fall nicht außer Betracht gelassen. Auf der Rückseite wird die strukturierte Diffusion mit Hilfe von unterschiedlichen Dotiermedien, in diesem Falle dem strukturierten Auftrag der erfindungsgemäßen Borpaste, wobei es sich im Prinzip genauso gut um eine erfindungsgemäße Bortinte handeln kann, erzielt. Der Wafer wird gleichzeitig einer konventionellen Gasphasendiffusion, beispielsweise mit Phosphorylchlorid als Dotierstoff-Precursor, unterzogen. Dadurch werden alle "offenen" Stellen des Siliziumwafers mit Phosphor dotiert. Die Flächen auf der Rückseite, welche mit dem erfindungsgemäßen borhaltigen Dotierstoff bedruckt sind, werden, aufgrund dessen Eigenschaft als Diffusionsbarriere gegenüber einer Phosphordiffusion zu wirken, nicht mit Phosphor, sondern durch das in der Dotierstoffquelle enthaltene Bor dotiert. In der Konsequenz wird auf der Rückseite die erwünschte strukturierte Dotierung erhalten. Die Vorderseite kann, muss jedoch nicht notwendigerweise, dabei einer zu hohen Dotierung unterzogen worden sein. Die Dotierintensität der Vorderseite wird durch kontrolliertes Zurückätzen der höchstdotierten Bereiche gezielt gegenüber den erwünschten Erfordernissen eingestellt.

In den folgenden Beispielen sind die bevorzugten Ausführungsformen der vorliegenden Erfindung wiedergegeben.

Wie oben ausgeführt, ermöglicht die vorliegende Beschreibung es dem Fachmann die Erfindung umfassend anzuwenden. Auch ohne weitere Ausführungen wird daher davon ausgegangen, dass ein Fachmann die obige Beschreibung im weitesten Umfang nutzen kann.

Bei etwaigen Unklarheiten versteht es sich von selbst, die zitierten Veröffentlichungen und Patentliteratur heranzuziehen. Dementsprechend gelten diese Dokumente als Teil der Offenbarung der vorliegenden Beschreibung. Dieses gilt insbesondere für die Offenbarungen der europäischen Patentanmeldungen mit den Aktenzeichen 14004453.8 und 14004454.6 und der internationalen Anmeldung WO 2014/101990 A.

Zum besseren Verständnis und zur Verdeutlichung der Erfindung werden im Folgenden Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Weiterhin versteht es sich für den Fachmann von selbst, dass sich sowohl in den gegebenen Beispielen als auch in der übrigen Beschreibung die in den Zusammensetzungen enthaltenen Komponentenmengen in der Summe immer nur zu 100 Gew.-, mol- oder vol.-% bezogen auf die Gesamtzusammensetzung aufaddieren und nicht darüber hinausgehen können, auch wenn sich aus den angegebenen Prozentbereichen höhere Werte ergeben könnten. Sofern nichts anderes angegeben ist, gelten daher %-Angaben als Gew.-, mol- oder vol.-%.

Die in den Beispielen und der Beschreibung sowie in den Ansprüchen gegebenen Temperaturen gelten immer in °C.

### Beispiele

### Beispiel 1:

In einem Glaskolben werden 55,2 g Ethylenglycolmonobutylether (EGB) und 20,1 g Aluminium-tri-sec-butylat (ASB) vorgelegt und gerührt, bis eine homogene Mischung entsteht. Zu dieser werden 7,51 g Eisessig, 0,8 g Acetaldoxim und 0,49 g Acetylaceton unter Rühren hinzugefügt. Anschließend werden 1,45 g Wasser, gelöst in 5 g EGB, tropfenweise hinzugefügt, und die Mischung wird bei 80 °C für fünf Stunden refluxiert. Nach dem Erwärmen wird die Mischung einer Vakuumdestillation bei 70 °C bis zum Erreichen eines Enddrucks von 30 mbar unterworfen. Der Massenverlust an leichtflüchtigen Reaktionsprodukten beträgt 12,18 g. Die destillierte Mischung wird anschließend mit 62,3 g Texanol und weiteren 65 g EGB verdünnt, sowie mit einem gemischten kondensierten Sol, bestehend aus Precursoren von Boroxid und Siliziumdioxid versetzt. Das Hybridsol aus Siliziumdioxid und Boroxid wird dazu wie folgt hergestellt: 6,3 g Tetraacetoxydiborat werden in 40 g Benzylbenzoat vorgelegt und mit 15 g Acetanhydrid versetzt. Die Mischung wird in einem Ölbad auf 80 °C erwärmt und nachdem eine klare Lösung entstanden ist, werden zu dieser Lösung 4,6 g Dimethyldimethoxysilan hinzugefügt und die ganze Mischung unter Rühren für 45 Minuten reagieren lassen. Das Hybridsol wird im Anschluss ebenfalls einer Vakuumdestillation bei 70 °C bis zum Erreichen eines Enddruckes von 30 mbar unterworfen, wobei der Massenverlust an leichtflüchtigen Reaktionsprodukten 7,89 g beträgt. Die 110 g der Gesamtmischung werden mit 9 g Synchrowachs versetzt und unter Rühren auf 150 °C bis zur vollständigen Lösung und klaren Durchmischung erwärmt. Im Anschluss wird die Mischung unter intensivem Rühren abkühlen lassen. Es entsteht eine strukturviskose und sehr gut druckbare Paste.

### Beispiel 2:

Die Paste gemäß des Beispiels 1 wird mit Hilfe einer konventionellen Siebdruckmaschine und einem Sieb mit 350 mesh, 16 µm Fadenstärke (Edelstahl) und einer Emulsionsdicke von 8 - 12 µm unter Anwendung einer Rakelgeschwindigkeit von 170 mm/s und einem Rakeldruck von 1 bar auf einen Wafer aufgedruckt und anschließend einer Trocknung in einem Durchlaufofen unterworfen. Die Heizzonen in dem Durchlaufofen werden auf 350/350/375/375/375/400/400 °C eingestellt.

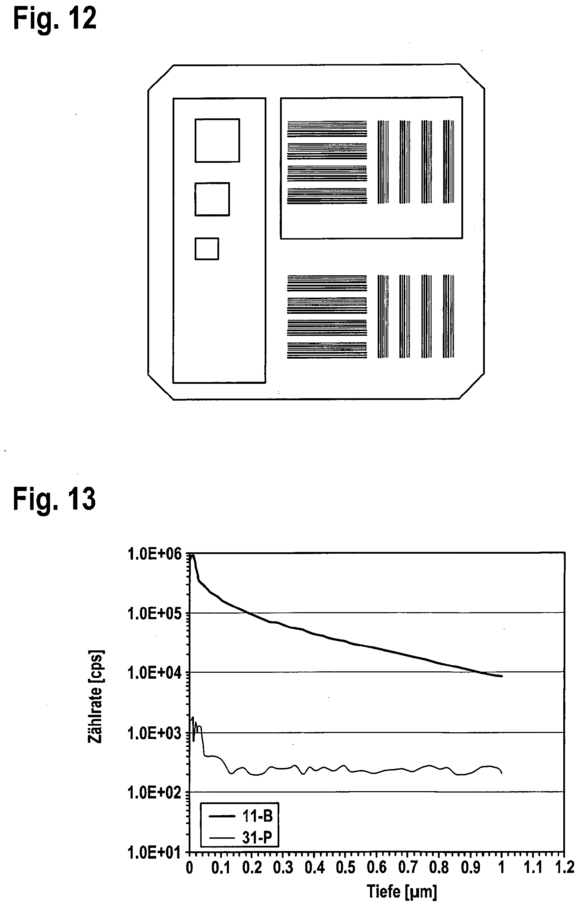

Figur 12 zeigt ein mit Hilfe des erfindungsgemäßen Hybridgels gemäß der Zusammensetzung und Herstellung des Beispiels 1 bedruckter Siliziumwafer nach dessen Trocknung in einem Durchlaufofen.

### Beispiel 3:

Die Paste gemäß des Beispiels 1 wird mit Hilfe einer konventionellen Siebdruckmaschine und einem Sieb mit 280 mesh und 25 µm Fadenstärke (Edelstahl) großflächig auf einer rauen CZ-Waferoberfläche (n-Typ) aufgedruckt. Der Nassauftrag beträgt 1,5 mg/cm². Der bedruckte Wafer wird anschließend auf einer konventionellen Laborheizplatte für 3 Minuten bei 300 °C getrocknet und anschließend einem Diffusionsprozess unterworfen. Dazu werden die Wafer bei ungefähr 700 °C in einen Diffusionsofen eingeschleust, und der Ofen wird anschließend auf eine Diffusionstemperatur von 950 °C aufgeheizt. Der Wafer wird für 30 Minuten bei dieser Plateautemperatur in einer Atmosphäre aus Stickstoff mit 0,2 % v/v Sauerstoff gehalten. Im Anschluss an die Bordiffusion wird der Wafer einer Phosphordiffusion mit Phosphorylchlorid bei niedriger Temperatur, 880 °C, in dem gleichen Prozessrohr ausgesetzt. Nach den Diffusionen und dem Abkühlen des Wafers wird dieser mittels Ätzung mit verdünnter Flusssäure von den auf den Waferoberflächen vorhandenen Gläsern befreit. Der Bereich, welcher zuvor mit der erfindungsgemäßen Borpaste bedruckt war, weist ein hydrophiles Benetzungsverhalten bei Spülung der Waferoberfläche mit Wasser auf, was einen eindeutigen Hinweis auf das Vorliegen einer Borhaut in diesem Bereich darstellt. Der in dem mit der Borpaste bedruckten Oberflächenbereich bestimmte Schichtwiderstand beträgt 195 Ω/sqr (p-Typ-Dotierung). Die nicht von der Borpaste geschützten Bereiche weisen einen Schichtwiderstand von 90 Ω/sqr auf (n-Typ-Dotierung). In dem Bereich der Oberfläche, welcher mittels der erfindungsgemäßen Borpaste bedruckt war, wird das SIMS-(Sekundärionen-Massenspektrometrie)-Tiefenprofil der Dotierstoffe bestimmt. In der mit der B-Paste bedeckten Region wird, ausgenommen der n-Typ-Basisdotierung, ein von der Waferoberfläche in die des Siliziums reichende Bordotierung bestimmt. Die aufgedruckte Pastenschicht wirkt somit als Diffusionsbarriere gegenüber einer typischen Phosphordiffusion.

Figur 13 zeigt das SIMS-Profil einer rauen Siliziumoberfläche, die mit der erfindungsgemäßen Borpaste bedruckt und anschließend einer Gasphasendiffusion mit Phosphorylchlorid unterworfen wurde. Aufgrund der rauen Oberfläche können nur relative Konzentrationen in Form von Zählraten erhalten werden.

### Beispiel 4:

In einem Rundkolben werden 3,66 g von in einem Exsikkator vorgetrockneter Borsäure in 40 g Dibenzylether, 8 g Acetanhydrid und 8 g Tetraethylorthosilicat unter Rühren bei 100 °C gelöst und für 30 Minuten reagieren lassen. Anschließend werden 60 g Ethylenglycolmonobutylether in einer Lösung aus 0,4 g 1,3-cyclohexandion und 7,2 g Saliclysäure gelöst und es werden 160 g Ethanol zugegeben. Nachdem die Reaktionsmischung vollständig durchmischt ist, werden zu dieser Lösung 20 g Aluminium-tri-sec-butylat zugesetzt. Die Lösung wird für eine weitere Stunde refluxiert. Die Bortinte wird anschließend durch einen Filter mit der Porengröße von 0,45 µm filtriert und entlüftet. Zum Verdrucken mittels eines Ink Jet-Druckers wird die Tinte in einen geeigneten Druckkopf, Spectra SE128AA, eingefüllt und unter Wahl der folgenden Druckbedingungen auf sauer glanzgeätzte Siliziumwafer aufgedruckt: Feuerfrequenz - 1500 Hz; Spannung - 70 V; Trapezfunktion - 1 - 11 - 1 µs; Unterdruckdifferenz über dem Tintentank - 21.5 mbar. Die Substrate werden auf der Substrathalterung von unten erwärmt. Die jeweilige Erwärmung (→ Drucktemperatur) ist in den aufgeführten Beispielen genannt. Auf den Wafern werden Quadrate mit einer Kantenlänge von jeweils 2 cm aufgedruckt. Die gewählte Druckauflösung ist ebenfalls in den einzelnen Beispielen wiedergegeben. Nach dem Drucken werden die bedruckten Wafer auf einer konventionellen Laborheizplatte bei Temperaturen zwischen 400 °C und 600 °C für jeweils fünf bis zehn Minuten getrocknet. Die getrockneten Strukturen werden anschließend mit einer Phosphortinte, gemäß der Zusammensetzung wie in der Patentanmeldung

WO 2014/101990 erwähnt, ebenfalls mittels Ink Jet Drucks bedruckt. Die jeweilige Druckauflösung, wie auch die jeweilige Drucktemperatur, ist in den Beispielen wiedergegeben. Die Phosphortinte wird unter Wahl der folgenden Druckbedingungen verarbeitet: Feuerfrequenz - 1500 Hz; Spannung - 90 V; Trapezfunktion - 1 - 11 - 1 µs; Unterdruckdifferenz über dem Tintentank - 21.5 mbar. Die gedruckte Struktur besteht ebenfalls aus einem Quadrat der Kantenlänge von jeweils 2 cm, welches auf dem Quadrat mit der Bortinte deponiert worden ist. Nach dem Drucken wird die Phosphortinte auf einer konventionellen Laborheizplatte bei Temperaturen zwischen 400 °C und 600 °C für jeweils fünf bis zehn Minuten getrocknet. Die gesamte Struktur wird anschließend einer Hochtemperaturdiffusion in einem Rohrofen bei 950 °C unterworfen. Dazu wird die Diffusion für 30 Minuten im Stickstoffstrom, gefolgt von einem Oxidationsprozess für fünf Minuten in einer Atmosphäre aus Stickstoff und Sauerstoff (20 % v/v) und weiterhin gefolgt von einer Eintreibephase von zehn Minuten in Stickstoffatmosphäre getrieben. Die diffundierten Wafer werden anschließend mittels Ätzens in verdünnter Flusssäure von den aufgedruckten Dotierstoffquellen befreit und das Dotierprofil wird mit Hilfe von elektrochemischer Kapazitäts-SpannungsMessung (ECV) in dem bedruckten Stellen gemessen.

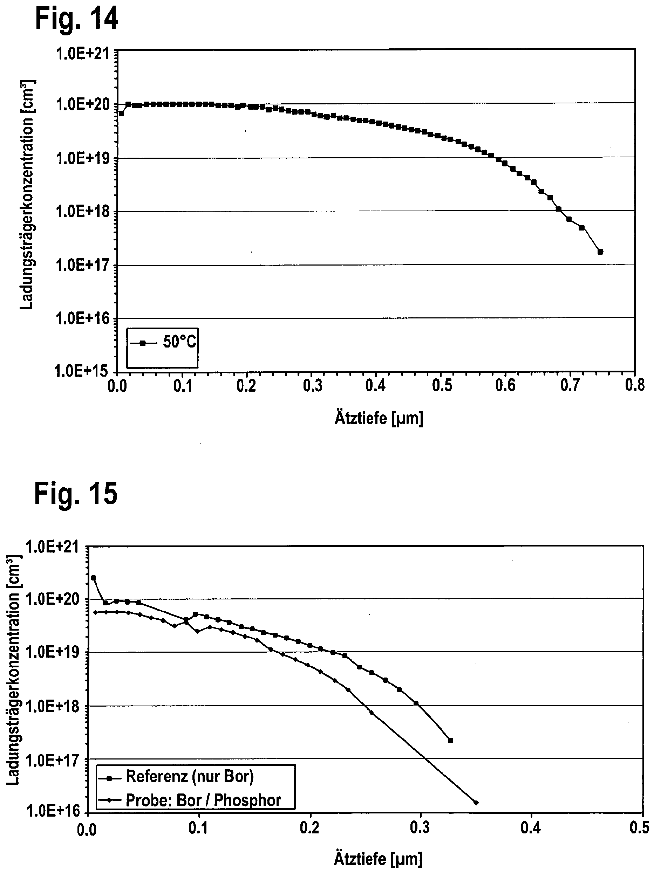

Figur 14 zeit das ECV-Profil eines mit der erfindungsgemäßen Bortinte bedruckten Siliziumwafers, welche anschließend mit Phosphortinte überschichtet und zur Diffusion gebracht wurde. Das Profil zeigt die Bordotierung, die sich bei Anwendung einer Druckauflösung von 508 dpi und einer Drucktemperatur von 50 °C ergab. In dem Profil wurde keine Phosphordotierung gemessen, zum Beispiel Wechsel des Ladungsträgertyps in unterschiedlichen Bereichen des Profils.

**Tabelle 1: Temperaturen und Druckauflösungen zu den oben beschriebenen Überschichtungsversuchen mit der erfindungsgemäßen Bortinte mittels einer ebenfalls mittels Ink Jet verdruckten Phosphortinte. Die Analyse der gedruckten und dotierten Sandwich-Strukturen resultierte in allen Fällen in einer im Siliziumwafer erzielten Bordotierung.**

| | Temperatur [°C] Bor | 40 | | 50 |
|---|---|---|---|---|
| Temperatur [°C] Phosphor | Druckauf lösung [dpi]: 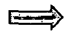 Bor Phosphor | 400 | 450 | 400 |
| 50 | 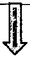 508 | B | B | B |
| 40 | 508 | B | B | B |
| 40 | 450 | B | B | B |
| 40 | 400 | B | B | B |
| 40 | 350 | B | B | B |
| 40 | 300 | B | B | B |
| 40 | 250 | B | B | B |
| 40 | 200 | B | B | B |

### Beispiel 5:

In einem Rundkolben werden 2 g Boroxid in 10,5 g Tetrahydrofuran, 3 g Acetanhydrid und 4 g Tetraethylorthosilicat unter Rühren und Refluxieren gelöst und für 30 Minuten reagieren lassen. Anschließend werden 41 g Ethylenglycolmonobutylether, in dem 2 g Salicylsäure und 0,6 g Acetylaceton vorgelöst sind, und 20 g Diethylenglycolmonoethylether zugegeben. Nachdem die Reaktionsmischung vollständig durchmischt ist, werden zu dieser Lösung 10 g Aluminium-tri-sec-butylat zugesetzt. Die Lösung wird für eine weitere Stunde refluxiert und anschließend werden an einem Rotationsverdampfer leichtflüchige Lösemittel und Reaktionsprodukte bei 60 °C unter Erreichen eines Enddruckes von 50 mbar abgezogen. Die Bortinte wird anschließend durch einen Filter mit der Porengröße von 0,45 µm filtriert und entlüftet. Anschließend werden einseitig polierte p-Typ Testwafer mittels des Lackschleuderverfahrens unter Anwendung eines zweistufigen Beschichtungsprogramms beschichtet: Schleudern für 15 s bei 500 rpm zum Verteilen der Tinte, gefolgt von 2000 rpm für 45 s. Die beschichteten Wafer werden anschließend auf einer konventionellen Laborheizplatte für fünf Minuten bei 500 °C getrocknet. Im Anschluss an diese Beschichtung werden die Wafer mit einer phosphorhaltigen Dotiertinte, gemäß der Zusammensetzung, wie in der Patentanmeldung WO 2014/101990 erwähnt, mit Hilfe des gleichen Schleuderprogramms auf der bereits mit Bortinte beschichteten Seite erneut beschichtet, wonach die Wafer ebenfalls für fünf Minuten bei 500 °C getrocknet werden. Die doppelt beschichteten Wafer werden in einem Rohrofen bei 930 °C im Stickstoffstrom für 30 Minuten zur Diffusion gebracht. Nach der Diffusion werden die Reste der Dotiermedien mit Hilfe von verdünnter Flusssäure von der Oberfläche entfernt, und die Wafer werden mit Hilfe von elektrochemischer Kapazitäts-Spannungsmessung (ECV) und Sekundär-Ionen-Massenspektrometrie (SIMS) hinsichtlich ihrer jeweiligen Dotierprofile beprobt.

Die Bortinte ist gegenüber der Diffusion von Phosphor aus der Phosphortinte dicht.

Figur 15 zeigt das ECV-Profil eines mit der erfindungsgemäßen Bortinte beschichteten Siliziumwafers, welcher anschließend mit Phosphortinte überschichtet und zur Diffusion gebracht wurde. In dem Profil wurde keine Phosphordotierung gemessen, zum Beispiel Wechsel des Ladungsträgertyps in unterschiedlichen Bereichen des Profils. Zum Vergleich ist ein ECV-Profil einer gleichbehandelten Referenzprobe dargestellt.

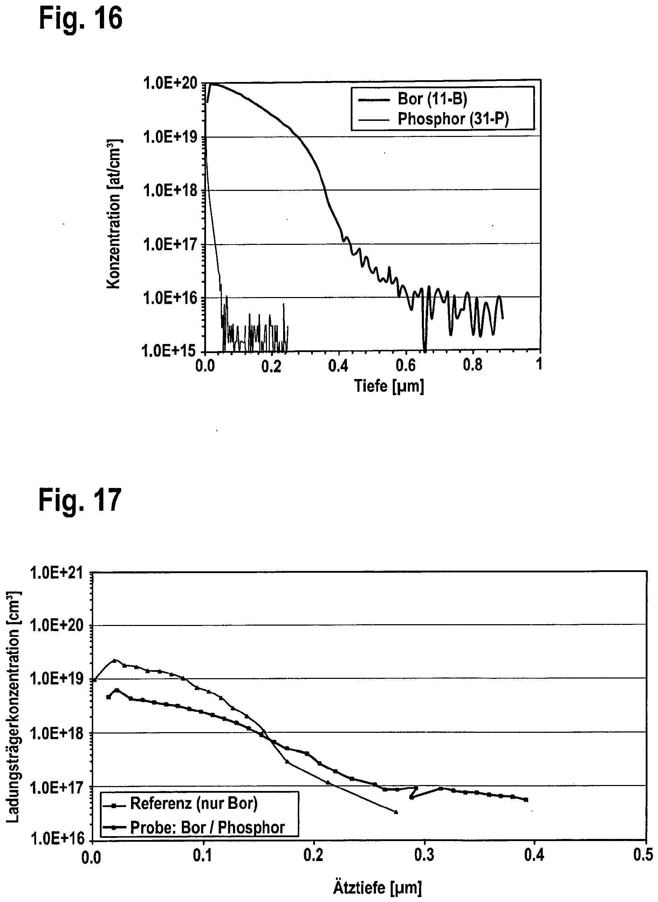

Figur 16 zeigt das SIMS-Profil einer, zu Figur 14 vergleichbaren Probe. Das SIMS-Profil zeigt die Konzentrationsverläufe von Bor und Phosphor in Silizium. Das Phosphorprofil erreicht nach einer Tiefe von 40 nm eine Konzentration von 1^{∗}10¹⁶ Atome/cm³.

In einem Vergleichsexperiment wird eine Bortinte, ausschließlich basierend auf einem Hybridsol bestehend aus Precursoren des Siliziumdioxids und Boroxids, gemäß der zuvor erwähnten Vorgehensweise hergestellt. Der Anteil des Aluminiumoxides wird hierbei durch Siliziumdioxid ersetzt. Die Tinte wird mittels Lackschleuderbeschichtung unter Anwendung des bereits genannten Beschichtungsprogramms aufgetragen und anschließend ebenfalls mit Phosphortinte überschichtet. Die doppelt beschichteten Proben werden der bereits beschriebenen Diffusion unterworfen und im Anschluss auf die gleiche Weise analysiert.

Figur 17 zeigt das ECV-Profil eines mit einer nicht erfindungsgemäßen Bortinte beschichteten Siliziumwafers, welcher anschließend mit Phosphortinte überschichtet und zur Diffusion gebracht wurde. In dem Profil wurde ausschließlich eine Phosphordotierung (blau) gemessen. Zum Vergleich ist ein ECV-Profil einer gleichbehandelten Referenzprobe dargestellt.

Figur 18 zeigt das SIMS-Profil einer, zu Figur 16 vergleichbaren Probe. Das SIMS-Profil zeigt die Konzentrationsverläufe von Bor und Phosphor in Silizium. Bei der im Silizium vorherrschenden Konzentration handelte es sich um Phosphor.

Das Hybridsol auf Basis von Silicumdioxid und Boroxid und gleichzeitiger Abwesenheit von Aluminiumoxid war gegenüber der Diffusion von Phosphor aus der Phosphortinte nicht diffusionsdicht.

### Beispiel 6:

In einem Glaskolben werden 72,2 g Ethylenglycolmonobutylether (EGB), 2,9 g Dimethyldimethoxysilan und 12,8 g Aluminium-tri-sec-butylat (ASB) vorgelegt und gerührt, bis eine homogene Mischung entsteht. Zu dieser Mischung werden 12,2 g Eisessig und 0,38 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 15,3 g. Die destillierte Mischung wird anschließend mit 84 g α-Terpineol (Isomerengemisch) und 3,76 g Tetraacetoxydiborat versetzt und intensiv durchmischt. Es entsteht eine strukturviskose und sehr gut druckbare, transparente Paste. Die Viskosität der Paste beträgt 8,5 Pa*s bei einer Scherrate von 25 1/s und einer Temperatur von 23 °C.

Die Paste wird mit Hilfe eines Siebdruckers unter Verwendung eines Trampolinsiebs mit Edelstahlgewebe (400 mesh, 18 µm Drahtdurchmesser, kalandriertes, 8 - 12µm Emulsion über dem Gewebe) auf alkalisch glanzgeätzten Wafern, unter Anwendung der folgenden Druckparameter verdruckt:
einem Siebabsprung von 2 mm,
einer Druckgeschwindigkeit von 200 mm/s,
einer Flutgeschwindigkeit von ebenfalls 200 mm/s,
einem Rakeldruck von 60 N während des Druckvorganges und einem Rakeldruck von 20 N während des Flutens, sowie unter der Verwendung einer Carbonfaserrakel mit Polyurethangummi der Shorehärte von 65 °.

Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 0,93 mg/cm².

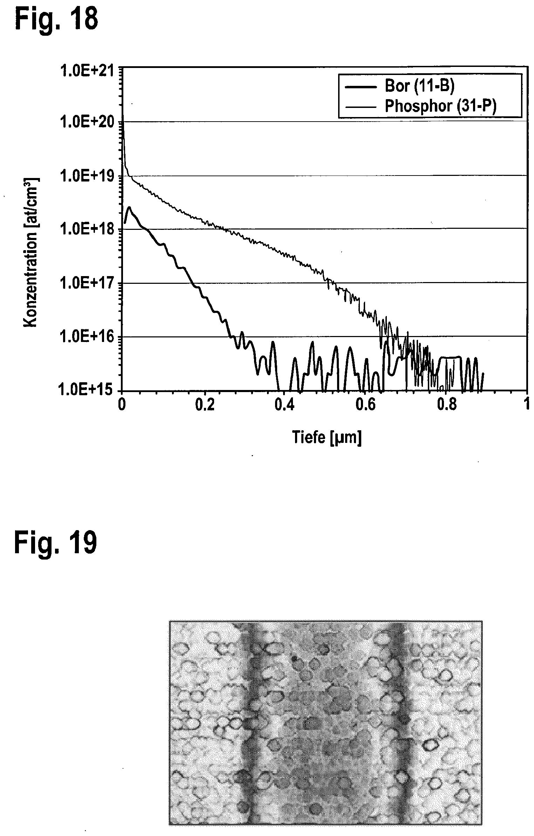

Figur 19 zeigt eine mikroskopische Aufnahme einer mit einer Dotierpaste gemäß des Beispiels 6 siebgedruckten und getrockneten Linie.

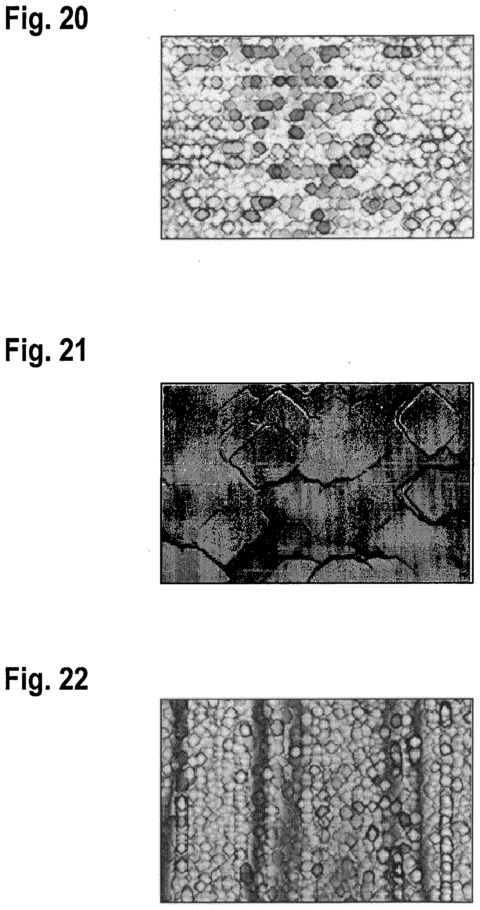

Figur 20 zeigt eine mikroskopische Aufnahme einer mit einer Dotierpaste gemäß des Beispiels 6 siebgedruckten und getrockneten Pastenfläche.

Figur 21 zeigt eine mikroskopische Aufnahme einer mit einer Dotierpaste gemäß des Beispiels 6 siebgedruckten und getrockneten Pastenfläche.

### Beispiel 7:

In einem Glaskolben werden 72,3 g Ethylenglycolmonobutylether (EGB), 2,8 g Dimethyldimethoxysilan und 12,9 g Aluminium-tri-sec-butylat (ASB) vorgelegt und gerührt, bis eine homogene Mischung entsteht. Zu dieser Mischung werden 12,1 g Eisessig und 1,5 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 15,3 g. Die destillierte Mischung wird anschließend mit 84 g α-Terpineol (Isomerengemisch) und 3,8 g Tetraacetoxydiborat versetzt und intensiv durchmischt. Es entsteht eine strukturviskose und sehr gut druckbare, transparente Paste. Die Viskosität der Paste beträgt 6,7 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 1,04 mg/cm².

Figur 22: Mikroskopische Aufnahme einer, mit einer Dotierpaste gemäß des Beispiels 7 siebgedruckten, und getrockneten Linie.

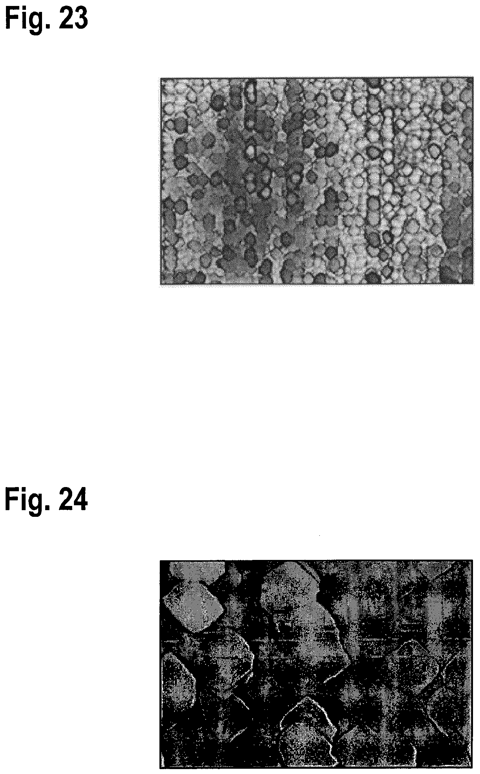

Figur 23: Mikroskopische Aufnahme einer, mit einer Dotierpaste gemäß des Beispiels 7 siebgedruckten, und getrockneten Pastenfläche

Figur 24: Mikroskopische Aufnahme einer, mit einer Dotierpaste gemäß des Beispiels 7 siebgedruckten, und getrockneten Pastenfläche

In einer weiteren Ausführungsweise werden sowohl alkalisch glanzgeätzte, als auch alkalisch texturierte und mittels einseitiger saurer Ätze nachpolierte CZ-n-typ Siliziumwafer annähernd ganzflächig (∼93 %) mit der Dotierpaste bedruckt. Der Druck erfolgt mit einem Sieb mit Edelstahlgewebe (400/18, 10 µm Emulsionsdicke über dem Gewebe). Der Pastenauftrag beträgt 0,9 mg/cm². Die Wafer werden für drei Minuten bei 400 °C auf einer Heizplatte getrocknet und anschließend einer Co-Diffusion bei einer Plateautemperatur von 950 °C für 30 Minuten unterworfen. Bei der Co-Diffusion wird der Wafer auf der mit der Borpaste bedruckten Seite mit Bor diffundiert und dotiert, wohingegen die Waferseite oder-oberftäche, die nicht mit Borpaste bedruckt ist, mit Phosphor diffundiert und dotiert wird. Die Phosphordiffusion wird in diesem Fall mit Hilfe von Phosphorylchloriddampf erzielt, welcher, transportiert durch einen Strom inerten Gases, in die heiße Ofenatmosphäre eingetragen wird. Infolge der im Ofen vorherrschenden hohen Temperatur und des gleichzeitig in der Ofenatmosphäre vorhandenen Sauerstoffs, wird das Phosphorylchlorid zu Phosphorpentoxid verbrannt. Das Phosphorpentoxid schlägt sich in Verbindung mit einem, sich auf der Waferoberfläche aufgrund des in der Ofenatmosphäre vorhandenen Sauerstoffs bildenden Siliziumdioxids nieder. Die Mischung aus dem Siliziumdioxid mit dem Phosphorpentoxid wird als auch als PSG-Glass bezeichnet. Aus dem PSG-Glass auf der Oberfläche erfolgt die Dotierung des Siliziumwafers. Auf Oberflächenbereichen, auf weichen bereits Borpaste vorhanden ist, kann sich ein PSG-Glass nur auf der Oberfläche der Borpaste bilden. Wenn die Borpaste als Diffusionsbarriere gegenüber Phosphor wirkt, dann kann an solchen Stellen, auf welchen bereits Borpaste vorhanden ist, keine Phosphordiffusion erfolgen, sondern nur eine von Born selbst, welches aus der Pastenschicht in den Siliziumwafer eindiffundiert. Diese Art der Co-Diffusion kann in verschiedenen Ausführungsformen durchgeführt werden. Prinzipiell kann das Phosphorylchlorid zu Beginn des Diffusionsprozesses in dem Ofen verbrannt werden. Unter Prozessbeginn versteht man bei der industriellen Herstellung von Solarzellen im Regelfall einen Temperaturbereich zwischen 600 °C und 800 °C, in welchem die zu diffundierenden Wafer in den Diffusionsofen eingefahren werden können. Weiterhin kann es während des Aufheizens des Ofens auf die gewünschte Prozesstemperatur in dem Ofenraum verbrannt werden. Das Einbringen von Phosphorylchlorid kann demgemäß auch während des Haltens der Plateautemperatur, als auch während des Abkühlens des Ofens oder vielleicht auch nach dem Erreichen einer zweiten Plateautemperatur, welche höher und/oder auch niedriger als die erste Plateautemperatur sein kann, in den Ofen eingebracht werden. Von den zuvor genannten Möglichkeiten können, je nach den jeweiligen Erfordernissen, auch beliebige Kombinationen der Phasen des möglichen Eintragens von Phosphorylchlorid in den Diffusionsofen vorgenommen werden. Einige dieser Möglichkeiten sind skizziert. In dieser Abbildung ist die Möglichkeit der Verwendung einer zweiten Plateautemperatur nicht dargestellt.

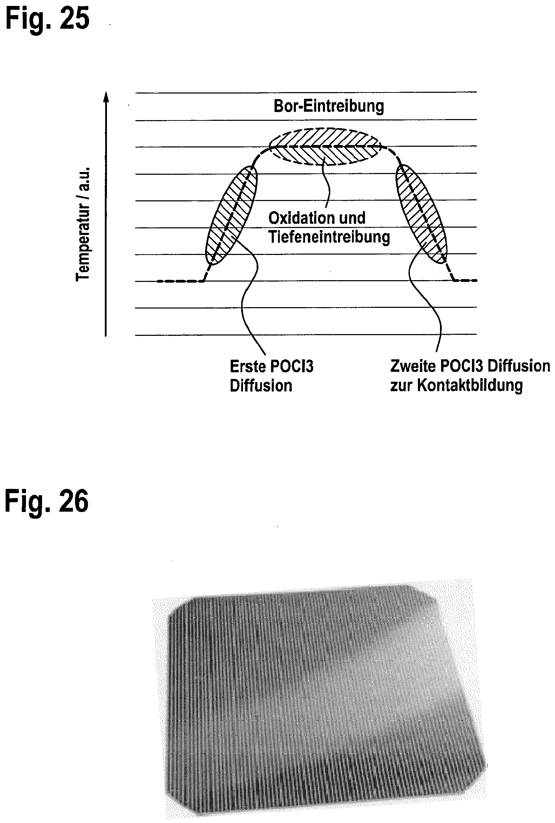

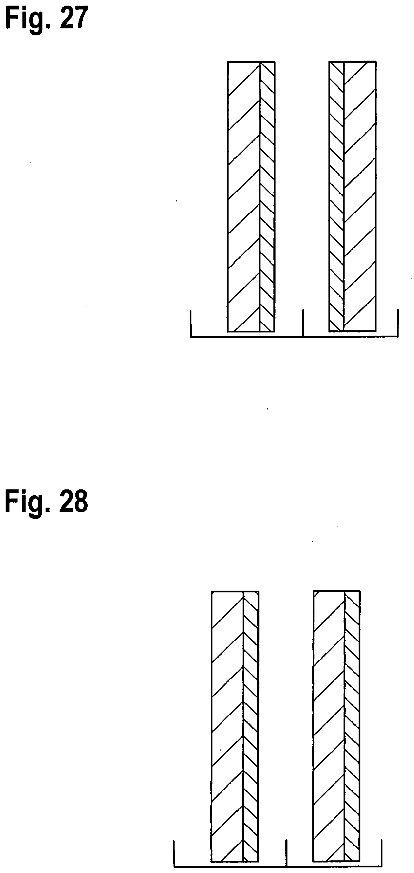

Die mit der Borpaste bedruckten Wafer werden einem, wie in Figur 25 dargestellt, Co-Diffusionprozess unterworfen, bei welchem der Eintrag des Phosphorylchlorids in den Diffusionsofen vor dem Erreichen der Plateautemperatur, welche zum Erzielen einer Bordiffusion notwendig ist, in diesem Fall 950 °C, erfolgt. Während der Diffusion sind die Wafer in dem Prozessboot paarweise dergestalt angeordnet, dass deren mit Borpaste bedruckten Seiten jeweils zueinander zeigen (vgl. Figur 27). Es wird jeweils ein Wafer in einem Schlitz des Prozessbootes aufgenommen. Der nominelle Abstand zwischen den Substraten beträgt damit etwa 2,5 mm. Im Anschluss an die Diffusion werden die Wafer einer Glasätze in verdünnter Flusssäure unterworfen und anschließend werden deren Schichtwiderstände mittels Vierpunktmessung gemessen. Die mit der Borpaste diffundierte Seite des Wafers verfügt über einen Schichtwiderstand von 35 Ω/□ (Spannweite: 10 Ω/□), wohingegen die der mit der Borpaste bedruckten gegenüberliegende Seite des Wafers einen Schichtwiderstand von 70 Ω/□ besitzt. Mit Hilfe eines p-n-Testers wird nachgewiesen, dass die Seite, welche über einen Schichtwiderstand von 35 Ω/□ verfügt ausschließlich p-, also mit Bor, dotiert ist, während die gegenüberliegende Seite, die über einen Schichtwiderstand von 70 Ω/□ verfügt, ausschließlich n-, also mit Phosphor dotiert ist. Zwischen den Schichtwiderständen auf den alkalisch glanzgeätzten Wafern und jenen, bei denen die alkalische Textur einseitig sauer nachpoliert wurde, kein grundlegender Unterschied besteht - sowohl auf der mit Phosphor, als auch auf der mit Bor dotierten Waferseite.

In einer weiteren, gleichen Ausführungsform des oben geschilderten Co-Diffusionsexperiments werden die Wafer in dem Prozessboot für die Diffusion dergestalt angeordnet, dass die mit der Borpaste bedruckte Waferseite einer nicht bedruckten Waferoberfläche gegenüber steht (vgl. Figur 28). Nach der oben bereits geschilderten post-diffusiven Nachbehandlung der Wafer werden die Schichtwiderstände, als auch die vorherrschenden Dotierungen mit den bereits genannten Methoden bestimmt. Auf der mit Borpaste bedruckten Seite wird ein Schichtwiderstand von 37 Ω/□ (Spannweite: 10 Ω/□) bestimmt. Diese Seite ist ausschließlich p-dotiert, während auf der Rückseite ein Schichtwiderstand von 70 Ω/□ von gemessen wird. Die Rückseite ist ausschließlich n-dotiert.

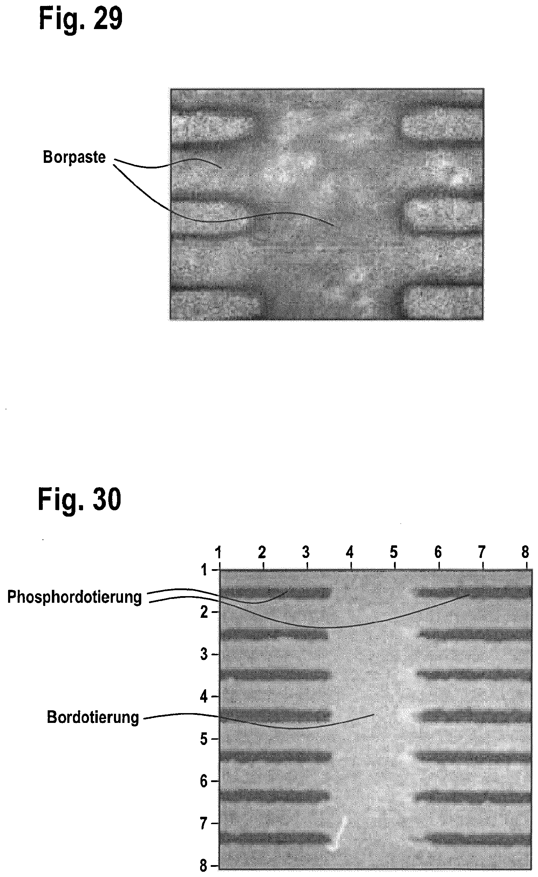

In einer weiteren Ausführungsform des bereits beschriebenen Co-Diffusionsexperiments werden Wafer mit der erfindungsgemäßen Borpaste mit einem Pastenauftrag von 0,7 mg/cm² bedruckt und den gleichen Diffusionsbedingungen unterworfen. Die Anordnung der Wafer in dem Prozessboot erfolgte gemäß der Figur 29. Nach der Aufarbeitung der diffundierten Wafer gemäß der bereits geschilderten Vorgehensweise, kann auf der mit der Borpaste bedruckten Seite ein Schichtwiderstand von 37 Ω/□ (Spannweite: 8 Ω/□) bestimmt werden. Bei der auf dieser Waferoberfläche vorherrschenden Dotierung handelt es sich um p-Typ.

In einer weiteren Ausführungsform des Co-Diffusionsexperiments werden Wafer mit der erfindungsgemäßen Borpaste mit einem Pastenübertrag von 0,9 mg/cm² bedruckt. Die bedruckten Wafer werden auf einer Heizplatte für drei Minuten bei 400 °C und daran anschließend in einem Durchlaufofen für weitere 20 Minuten getrocknet. Die Wafer werden einem bereits oben beschriebenen Co-Diffusionsexperiment unterzogen, wobei die mit Borpaste bedruckten Waferoberflächen jeweils gegenüber liegend angeordnet sind.

Nach der Diffusion werden die Wafer in der gewohnten Weise weiterbehandelt und anschließen wird auf der mit der Paste bedruckten Seite der Schichtwiderstand mittels Vierpunktmessung bestimmt. Der Schichtwiderstand beträgt 41 Ω/□ (Spannweite: 5 Ω/□). Die intensivierte Trocknung der Paste führt zu einer deutlichen Reduktion der Varianz des Schichtwiderstandes.

In einer weiteren Ausführungsform der Co-Diffusion werden Wafer mit einem Sieb unter Verwendung eines strukturierten Sieblayouts verdruckt. Das verwendete Sieb entspricht den bereits oben erwähnten Charakteristika. Des Weiteren verfügt das Sieb über einen mittig auf der Waferoberfläche aufzudruckenden Sammelbus, von welchem jeweils 700 µm breite Balken oder Finger nach sowohl rechts, als auch links abzweigen. Zwischen den Balken befinden sich 300 µm breite Stege, welche die Waferoberfläche vor dem Pastendruck schützen. Die dergestalt bedruckten Wafer werden auf einer Heizplatte bei 400 °C für drei Minuten getrocknet, anschließend in einer Anordnung gemäß der Figur 28 in dem Prozessboot ausgerichtet und unter Anwendung der bereits beschriebenen Co-Diffusionsbedingungen zur Diffusion gebracht. Nach der weiteren, bereits oben beschriebenen Behandlung der diffundierten Wafer, werden diese mittels eines bildgebenden Verfahrens zur Bestimmung der Schichtwiderstandes untersucht (sheet resistance imaging). Die verwendete Messmethode erfolgte unkalibriert, was bedeutet, dass die Schichtwiderstandsinformationen über die von Messmethode erhaltenen Signale und Signaländerungen codiert sind (in diesem Fall Zählraten der mit Hilfe des Verfahrens detektierten IR-Strahlung). In der Figur 29 ist eine mikroskopische Aufnahme einer gedruckten Struktur nach der Co-Diffusion dargestellt. Auf der Probe liegt die Borpaste noch vor. Die mit der Borpaste bedruckten Bereiche weisen eine dunkelblaue Farbe auf. Ein Wafer, der mit der erfindungsgemäßen Borpaste bedruckt und getrocknet ist, ist dargestellt: die in dieser Abbildung gezeigte Struktur entspricht im Prinzip der zuvor beschriebenen Strukturgebung, ausgenommen, dass der als mittig angeordnete Sammelbus auf dieser Waferoberfläche nicht vorliegt und die Abmessungen der gedruckten Balken nicht exakt den ebenfalls bereits genannten Abmessungen entsprechen. Die aus der Figur 29 ersichtlichen Strukturen werden in die, in der Figur 30 gezeigten Schichtwiderstandskartierung übertragen. Die in der Figur 30 orange-rot dargestellten Bereiche entsprechen den mit der Borpaste gedruckten Strukturen, während die roten Bereiche den Aussparungen in der Struktur zuzuordnen sind, die infolge der Co-Diffusion mit Phosphor diffundiert wurden. Es ist darüber hinaus zu erkennen, dass die benachbarten Bereiche über eine, mit der Messgenauigkeit der zur Verfügung stehenden Mittel und unter Berücksichtigung der gemessenen Waferoberflächen (Streuung des Signals), sehr scharfe Abgrenzung und sehr gut definierten Übergangsbereich verfügen. In der Figur 30 sind gemäß der Versuchsausführung alternierende, scharf abgegrenzte pn-Übergänge gezeigt, die mit Hilfe eines einzigen Hochtemperatur-Diffusionsschrittes hergestellt werden können.

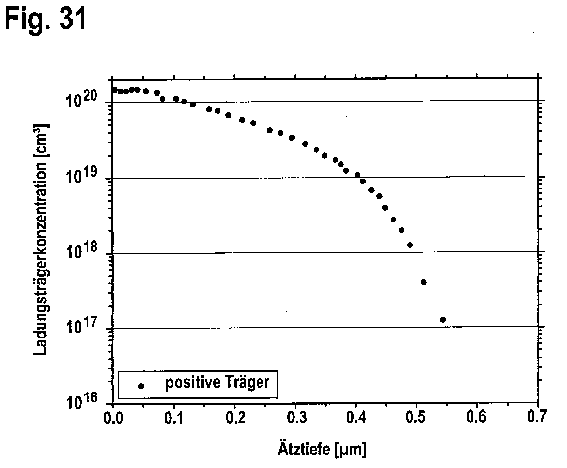

Des Weiteren ist in Figur 31 ein ECV-Profil (elektrochemische Kapazitäts-Spannungs-Profilierung) der mit Hilfe der erfindungsgemäßen Borpaste hergestellten, und der in Figur 29 und auch der in Figur 30 gezeigten Busbar-Region dargestellt. Das Profil zeigt ein Emitterprofil mit einer Tiefe des pn-Überganges von etwa 600 nm an. Es herrscht ausschließlich eine p-typ-Dotierung vor. Die Oberflächenkonzentration der Ladungsträger (Löcher) des Emitterprofils beträgt etwa 2^{∗}10²⁰ cm⁻³. Durch geeignete Manipulationen der Prozessführung des Co-Diffusionsprozesses kann sowohl die Tiefe des Profils als auch die Oberflächenkonzentration in gewünschter Weise eingestellt werden (z. B. durch die Wahl der Diffusionstemperatur, der Diffusionslänge, der Zusammensetzung der während des Diffusionsprozesses verwendeten Gasatmosphäre, und hierbei insbesondere durch die Einstellung einer dezidierten Sauerstoffkonzentration).

Figur 25 zeigt eine mikroskopische Aufnahme einer, mit einer Dotierpaste gemäß des Beispiels 7 siebgedruckten, und getrockneten Linie.

Figur 26 zeigt die photographische Aufnahme eines, mit Borpaste gemäß des Beispiels 7 in Form einer Balkenstruktur bedruckten monokristallinen Siliziumwafers.

Figur 27 zeigt eine Anordnung von Wafern in einem Prozessboot während eines Co-Diffusionsprozesses. Die mit Borpaste bedruckten Waferoberflächen sind gegenüberliegend.

Figur 28 zeigt eine Anordnung von Wafern in einem Prozessboot während eines Co-Diffusionsprozesses. Die mit Borpaste bedruckten Waferoberflächen sind gegenüberliegend.

Figur 29 zeigt eine mikroskopische Aufnahme eines mit der erfindungsgemäßen Borpaste bedruckten Wafers (alkalisch texturierte, einseitig sauer nachpolierte Waferoberfläche). Die nominellen Bemessungen der aufgedruckten Struktur sind im Text erwähnt.

Figur 30 zeigt eine Schichtwiderstandskartierung mit Hilfe des SRI-Verfahrens. Die orange-gelben Bereiche entsprechen einer Bordotierung, wohingegen die roten Bereiche einer Phosphordotierung zuzuordnen sind. Die gezeigte Struktur entspricht derjenigen, in der Figur 29 dargestellten.

Figur 31 zeigt ein ECV-Profil eines mittels der erfindungsgemäßen Borpaste und unter Anwendung eines Co-Diffusionsprozesses erhaltenes EmitterProfil (Bor, p-typ). Die Tiefe des pn-Überganges beträgt etwa 600 nm. Die Oberflächenkonzentration der Ladungsträger (Löcher) beträgt etwa 2^{∗}10²⁰ cm⁻³.

### Beispiel 8:

In einem Glaskolben werden 563,2 g Ethylenglycolmonobutylether (EGB), 23 g Dimethyldimethoxysilan und 102,2 g Aluminium-tri-sec-butylat (ASB) vorgelegt und gerührt, bis eine homogene Mischung entsteht. Zu dieser Mischung werden 97,8 g Eisessig und 6 g Acetaldoxim in der genannten Reihenfolge unter Rühren hinzugefügt. Anschließend werden 15,6 g Wasser, gelöst in 50 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 119,6 g. Die destillierte Mischung wird anschließend mit 782 g α-Terpineol (Isomerengemisch) und 32,2 g Tetraacetoxydiborat versetzt und intensiv durchmischt. Es entsteht eine strukturviskose und sehr gut druckbare, transparente Paste. Die Viskosität der Paste beträgt 7,5 Pa*s bei einer Scherrate von 25 1/s und einer Temperatur von 23 °C.

Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt:
einem Siebabsprung von 2 mm,
einer Druckgeschwindigkeit von 200 mm/s,
einer Flutgeschwindigkeit von ebenfalls 200 mm/s,
einem Rakeldruck von 60 N während des Druckvorganges und einem Rakeldruck von 20 N während des Flutens sowie unter der Verwendung einer Carbonfaserrakel mit Polyurethangummi der Shorehärte von 65°.

Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 1,17 mg/cm².

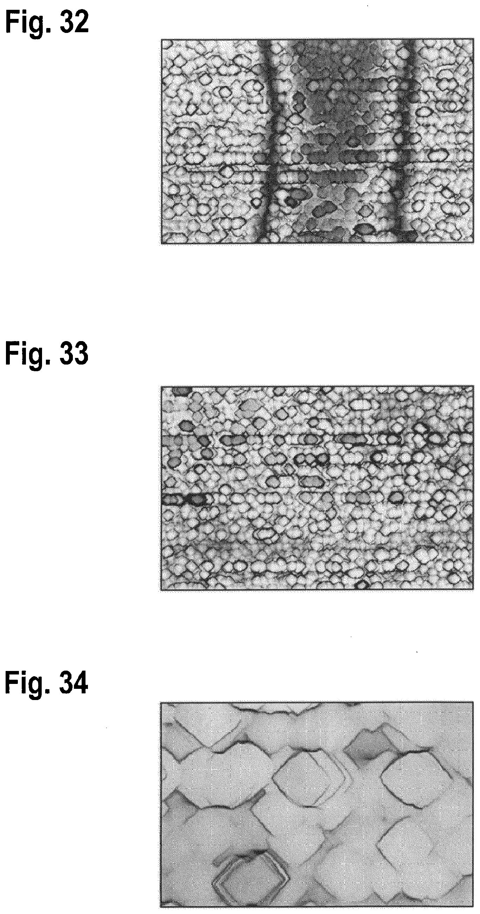

Figur 32 zeigt eine mikroskopische Aufnahme einer, mit einer Dotierpaste gemäß des Beispiels 8 siebgedruckten, und getrockneten Linie.

Figur 33 zeigt ein mikroskopische Aufnahme einer, mit einer Dotierpaste gemäß des Beispiels 8 siebgedruckten, und getrockneten Pastenfläche

Figur 34 zeigt eine mikroskopische Aufnahme einer, mit einer Dotierpaste gemäß des Beispiels 8 siebgedruckten, und getrockneten Pastenfläche.

### Beispiel 9:

In einem Glaskolben werden 72,5 g Ethylenglycolmonobutylether (EGB), 2,9 g Dimethyldimethoxysilan und 12,8 g Aluminium-tri-sec-butylat (ASB) vorgelegt und gerührt, bis eine homogene Mischung entsteht. Zu dieser Mischung werden 12,2 g Eisessig und 1,4 g 1,3-Cyclohexandion in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 20,8 g. Die destillierte Mischung wird anschließend mit 103 g α-Terpineol (Isomerengemisch) und 3,9 g Tetraacetoxydiborat versetzt und intensiv durchmischt. Es entsteht eine strukturviskose und sehr gut druckbare, transparente Paste. Die Viskosität der Paste beträgt 19,3 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 1,15 mg/cm².

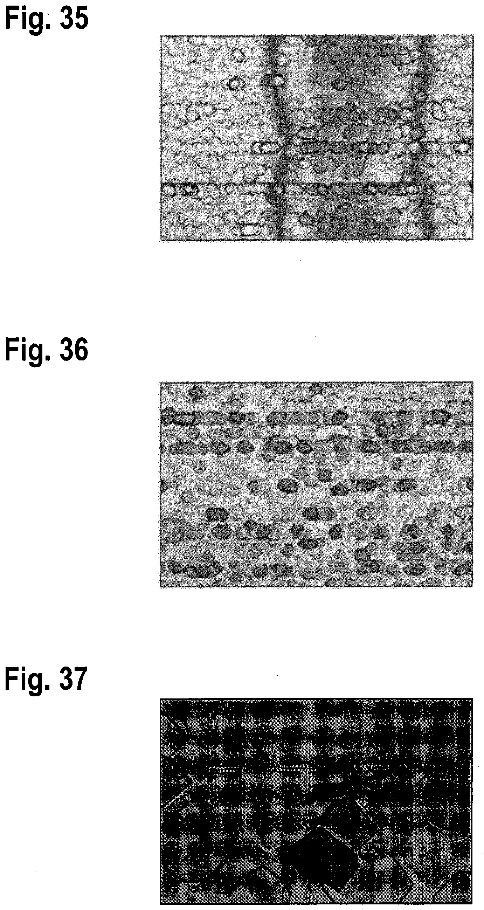

Figur 35 zeigt eine mikroskopische Aufnahme einer, mit einer Dotierpaste gemäß des Beispiels 9 siebgedruckten, und getrockneten Linie.

Figur 36 zeigt eine mikroskopische Aufnahme einer, mit einer Dotierpaste gemäß des Beispiels 9 siebgedruckten, und getrockneten Pastenfläche.

Figur 37 zeigt eine mikroskopische Aufnahme einer, mit einer Dotierpaste gemäß des Beispiels 9 siebgedruckten, und getrockneten Pastenfläche.

### Beispiel 10:

In einem Glaskolben werden 74,2 g Ethylenglycolmonobutylether (EGB), 2,9 g Dimethyldimethoxysilan und 12,9 g Aluminium-tri-sec-butylat (ASB) vorgelegt und gerührt, bis eine homogene Mischung entsteht. Zu dieser Mischung werden 12,3 g Eisessig und 1,9 g 3,5-Dihydroxybenzoesäure in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 20,5 g. Die destillierte Mischung wird anschließend mit 96,5 g α-Terpineol (Isomerengemisch) und 3,9 g Tetraacetoxydiborat versetzt und intensiv durchmischt. Es entsteht eine strukturviskose und sehr gut druckbare, transparente Paste. Die Viskosität der Paste beträgt 23,8 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 1,08 mg/cm².

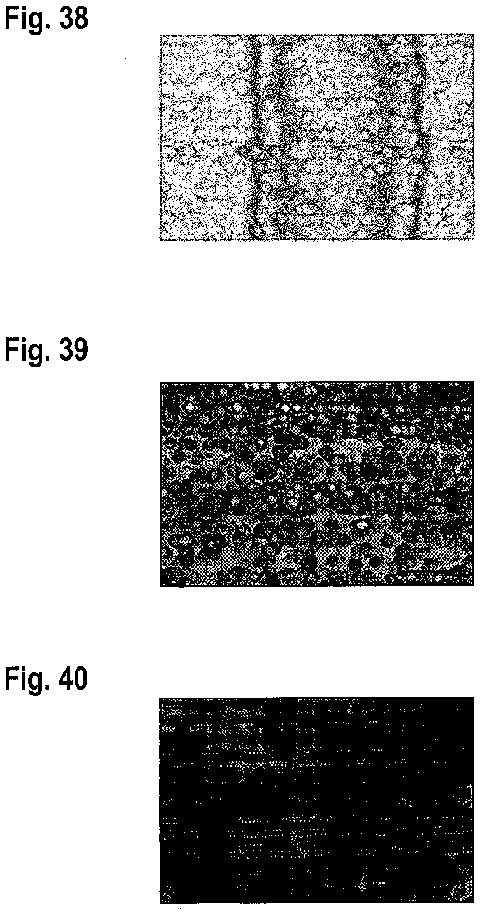

Figur 38 zeigt eine mikroskopische Aufnahme einer, mit einer Dotierpaste gemäß des Beispiels 10 siebgedruckten, und getrockneten Linie

Figur 39 zeigt eine mikroskopische Aufnahme einer, mit einer Dotierpaste gemäß des Beispiels 10 siebgedruckten, und getrockneten Pastenfläche

Figur 40 zeigt eine mikroskopische Aufnahme einer, mit einer Dotierpaste gemäß des Beispiels 10 siebgedruckten, und getrockneten Pastenfläche.

### Beispiel 11:

In einem Glaskolben werden 72,2 g Ethylenglycolmonobutylether (EGB), 2,9 g Dimethyldimethoxysilan und 12,8 g Aluminium-tri-sec-butylat (ASB) vorgelegt und gerührt, bis eine homogene Mischung entsteht. Zu dieser Mischung werden 12,3 g Eisessig und 1,6 g Salicylsäure in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 16,9 g. Die destillierte Mischung wird anschließend mit 94,5 g α-Terpineol (Isomerengemisch) und 4 g Tetraacetoxydiborat versetzt und intensiv durchmischt. Es entsteht eine strukturviskose und sehr gut druckbare, transparente Paste. Die Viskosität der Paste beträgt 8,4 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserraket mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 0,92 mg/cm².

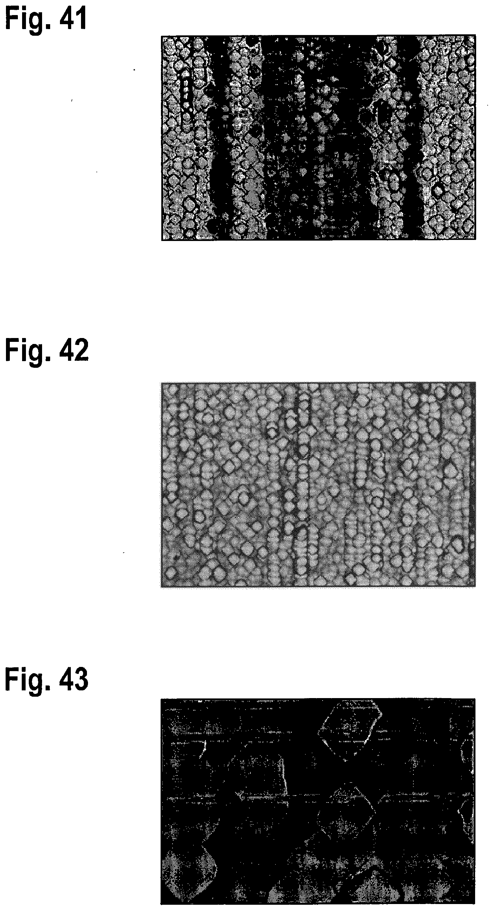

Figur 41 zeigt eine mikroskopische Aufnahme einer, mit einer Dotierpaste gemäß des Beispiels 11 siebgedruckten, und getrockneten Linie.

Figur 42 zeigt eine mikroskopische Aufnahme einer, mit einer Dotierpaste gemäß des Beispiels 11 siebgedruckten, und getrockneten Pastenfläche.

Figur 43 zeigt eine mikroskopische Aufnahme einer, mit einer Dotierpaste gemäß des Beispiels 11 siebgedruckten, und getrockneten Pastenfläche.

### Beispiel 12:

In einem Glaskolben werden 72,3 g Ethylenglycolmonobutylether (EGB), 2,9 g Dimethyldimethoxysilan und 12,9 g Aluminium-tri-sec-butylat (ASB) vorgelegt und gerührt, bis eine homogene Mischung entsteht. Zu dieser Mischung werden 12,2 g Eisessig und 0,56 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 21,6 g. Die destillierte Mischung wird anschließend mit 108 g α-Terpineol (Isomerengemisch) und 3,9 g Tetraacetoxydiborat versetzt und intensiv durchmischt. Es entsteht eine strukturviskose und sehr gut druckbare, transparente Paste. Die Viskosität der Paste beträgt 9,3 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 1,06 mg/cm².

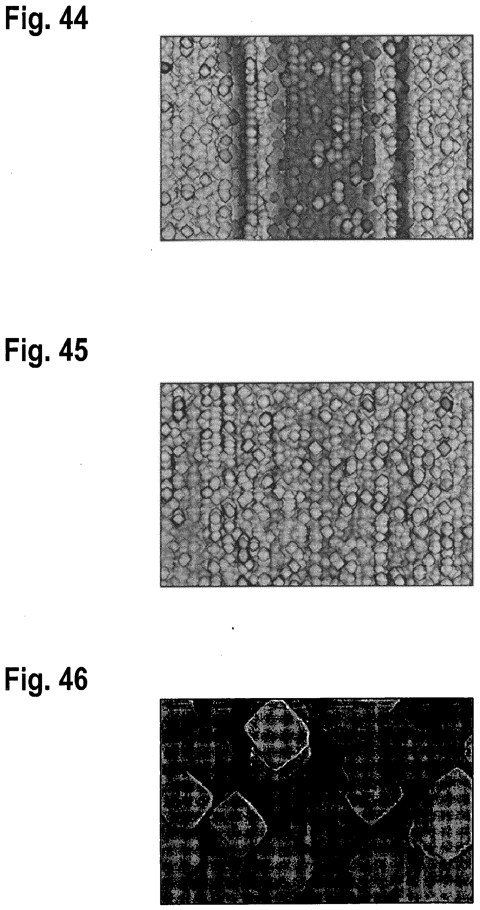

Figur 44 zeigt eine mikroskopische Aufnahme einer, mit einer Dotierpaste gemäß des Beispiels 12 siebgedruckten, und getrockneten Linie.

Figur 45 zeigt eine mikroskopische Aufnahme einer, mit einer Dotierpaste gemäß des Beispiels 12 siebgedruckten, und getrockneten Pastenfläche.

Figur 46 zeigt eine mikroskopische Aufnahme einer, mit einer Dotierpaste gemäß des Beispiels 12 siebgedruckten, und getrockneten Pastenfläche.

### Beispiel 13:

In einem Glaskolben werden 72,1 g Ethylenglycolmonobutylether (EGB), 2,9 g Dimethyldimethoxysilan und 12,8 g Aluminium-tri-sec-butylat (ASB) vorgelegt und gerührt, bis eine homogene Mischung entsteht. Zu dieser Mischung werden 12,3 g Eisessig und 1,1 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 19,3 g. Die destillierte Mischung wird anschließend mit 99 g α-Terpineol (Isomerengemisch) und 3,9 g Tetraacetoxydiborat versetzt und intensiv durchmischt. Es entsteht eine strukturviskose und sehr gut druckbare, transparente Paste. Die Viskosität der Paste beträgt 5,9 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m. Der Pastenübertrag beträgt 0,86 mg/cm².

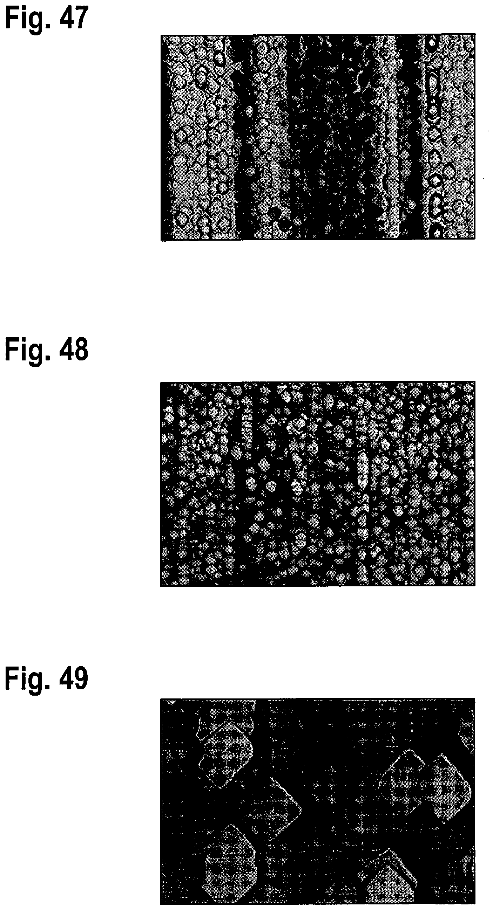

Figur 47 zeigt eine Mikroskopische Aufnahme einer, mit einer Dotierpaste gemäß des Beispiels 13 siebgedruckten, und getrockneten Linie.

Figur 48 zeigt eine Mikroskopische Aufnahme einer, mit einer Dotierpaste gemäß des Beispiels 13 siebgedruckten, und getrockneten Pastenfläche.

Figur 49 zeigt eine Mikroskopische Aufnahme einer, mit einer Dotierpaste gemäß des Beispiels 13 siebgedruckten, und getrockneten Pastenfläche.

### Beispiel 14:

In einem Glaskolben werden 577,2 g Ethylenglycolmonobutylether (EGB), 19,9 g Tetraethylorthosilicat, 19,9 g 1,2-Bis(triethoxysilyl)ethan und 102,2 g Aluminium-tri-sec-butylat (ASB) vorgelegt und gerührt, bis eine homogene Mischung entsteht. Zu dieser Mischung werden 97,8 g Eisessig und 6 g Acetaldoxim in der genannten Reihenfolge unter Rühren hinzugefügt. Anschließend werden 15,6 g Wasser, gelöst in 50 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 269,7 g. Die destillierte Mischung wird anschließend mit 782 g α-Terpineol (Isomerengemisch) und 32,2 g Tetraacetoxydiborat versetzt, intensiv durchmischt und abschließend werden weitere 100 ml Ethylenglycolmonobutylether hinzugefügt. Es entsteht eine strukturviskose und sehr gut druckbare, transparente Paste. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m.

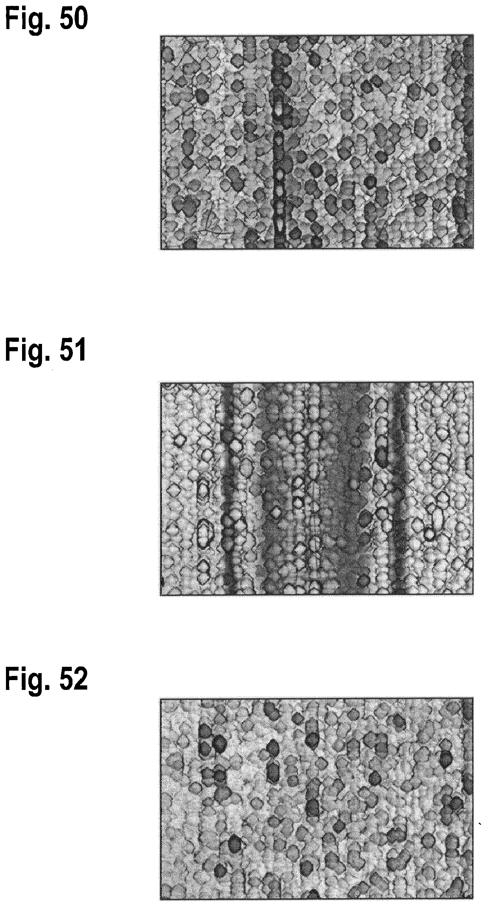

Figur 50 zeigt eine mikroskopische Aufnahme einer, mit einer Dotierpaste gemäß des Beispiels 14 siebgedruckten, und getrockneten Pastenfläche.

### Beispiel 15:

In einem Glaskolben werden 60 g Ethylenglycolmonobutylether (EGB), 1,7 g Tetraethylorthosilicat, 1,4 g 1,2-Bis(triethoxysilyl)ethan, 1 g Dimethyldimethoxysilan und 12,8 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 17,5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 15,2 g. Die destillierte Mischung wird anschließend mit 85 g α-Terpineol (Isomerengemisch) und 4 g Tetraacetoxydiborat versetzt, intensiv durchmischt. Es entsteht eine strukturviskose und sehr gut druckbare, transparente Paste. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m.

Figur 51 zeigt eine mikroskopische Aufnahme einer, mit einer Dotierpaste gemäß des Beispiels 15 siebgedruckten, und getrockneten Linie.

Figur 51 zeigt eine mikroskopische Aufnahme einer, mit einer Dotierpaste gemäß des Beispiels 15siebgedruckten, und getrockneten Pastenfläche.

### Beispiel 16:

In einem Glaskolben werden 72 g Ethylenglycolmonobutylether (EGB), 1,3 g 1,2-Bis(triethoxysilyl)ethan, 2 g Dimethyldimethoxysilan und 12,8 g Aluminium-tri-sec-butylat (ASB) vorgelegt und gerührt, bis eine homogene Mischung entsteht. Zu dieser Mischung werden 12,2 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 15,3 g. Die destillierte Mischung wird anschließend mit 92 g α-Terpineol (Isomerengemisch) und 3,9 g Tetraacetoxydiborat versetzt, intensiv durchmischt. Es entsteht eine strukturviskose und sehr gut druckbare, transparente Paste. Die Viskosität der Paste beträgt 10,6 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m.

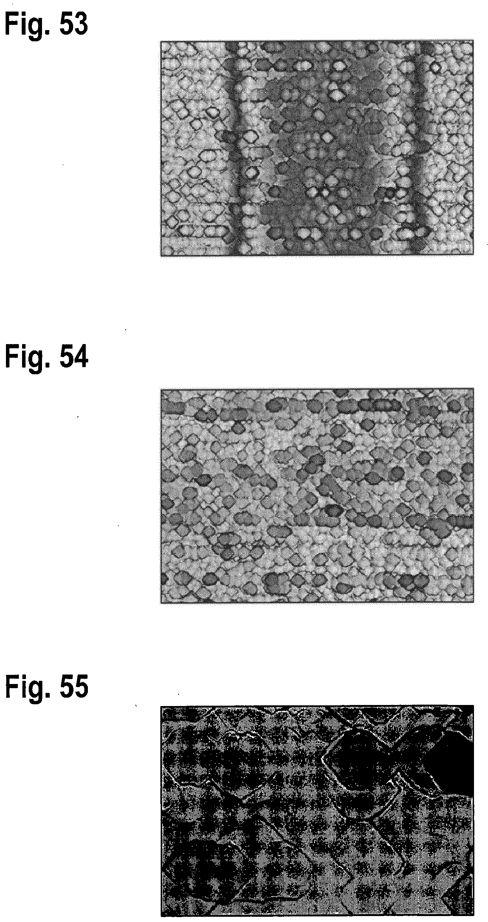

Figur 53 zeigt eine mikroskopische Aufnahme einer, mit einer Dotierpaste gemäß des Beispiels 16 siebgedruckten, und getrockneten Linie.

Figur 54 zeigt eine mikroskopische Aufnahme einer, mit einer Dotierpaste gemäß des Beispiels 16 siebgedruckten, und getrockneten Pastenfläche

Figur 55 zeigt eine mikroskopische Aufnahme einer, mit einer Dotierpaste gemäß des Beispiels 16 siebgedruckten, und getrockneten Pastenfläche.

### Beispiel 17:

In einem Glaskolben werden 72,2 g Ethylenglycolmonobutylether (EGB), 0,4 g 1,2-Bis(triethoxysilyl)ethan, 2,6 g Dimethyldimethoxysilan und 12,9 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Der Massenverlust an leichtflüchtigen Reaktionsprodukten beträgt 15,3 g. Die destillierte Mischung wird anschließend mit 92 g α-Terpineol (Isomerengemisch) und 4 g Tetraacetoxydiborat versetzt, intensiv durchmischt. Es entsteht eine strukturviskose und sehr gut druckbare, transparente Paste. Die Viskosität der Paste beträgt 5,4 Pa*s bei einer Scherrate von 25 1/s und einer Temperatur von 23 °C. Die Paste wird mit Hilfe eines Siebdruckers unter Verwendung eines Trampolinsiebs mit Edelstahlgewebe (400 mesh, 18 µm Drahtdurchmesser, kalandriert, 8 - 12 µm Emulsion über dem Gewebe) auf alkalisch glanzgeätzten Wafern, unter Anwendung der folgenden Druckparameter verdruckt: einem Siebabsprung von 2 mm, einer Druckgeschwindigkeit von 200 mm/s, einer Flutgeschwindigkeit von ebenfalls 200 mm/s, einem Rakeldruck von 60 N während des Druckvorganges und einem Rakeldruck von 20 N während des Flutens sowie unter der Verwendung einer Carbonfaserrakel mit Polyurethangummi der Shorehärte von 65 °. Die bedruckten Wafer werden anschließend in einem auf 400 °C erwärmten Durchlaufofen getrocknet. Die Bandgeschwindigkeit beträgt 90 cm/s. Die Länge der Heizzonen beträgt 3 m.

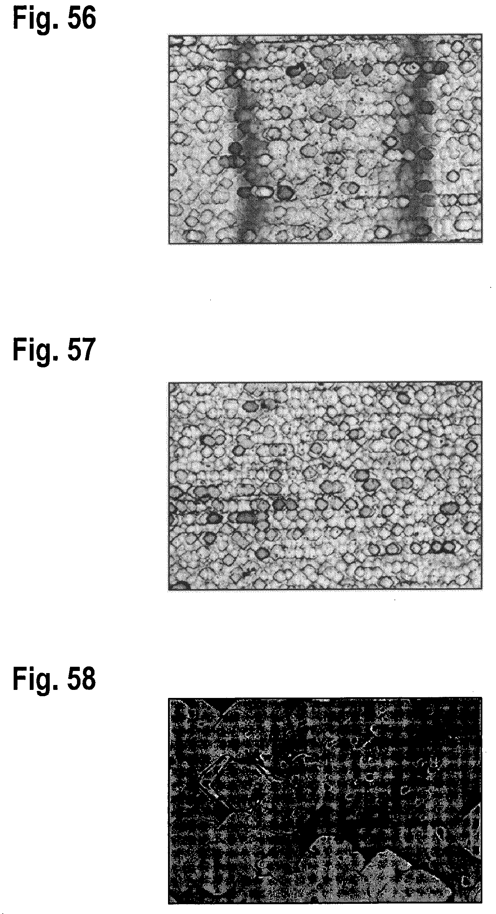

Figur 56 zeigt eine mikroskopische Aufnahme einer, mit einer Dotierpaste gemäß des Beispiels 17 siebgedruckten, und getrockneten Linie.

Figur 57 zeigt eine mikroskopische Aufnahme einer, mit einer Dotierpaste gemäß des Beispiels 17 siebgedruckten, und getrockneten Pastenfläche.

Figur 58 zeigt eine mikroskopische Aufnahme einer, mit einer Dotierpaste gemäß des Beispiels 17 siebgedruckten, und getrockneten Pastenfläche

### Beispiel 18:

In einem Glaskolben werden 72,2 g Ethylenglycolmonobutylether (EGB), 3,55 g Trimethoxyvinylsilan und 12,9 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Die destillierte Mischung wird anschließend mit 97 g α-Terpineol (Isomerengemisch) und 4 g Tetraacetoxydiborat versetzt und intensiv durchmischt. Es entsteht eine strukturviskose und sehr gut druckbare, transparente Paste.

### Beispiel 19:

In einem Glaskolben werden 72,2 g Ethylenglycolmonobutylether (EGB), 5,85 g Dimethoxydiphenylsilan und 12,9 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Die destillierte Mischung wird anschließend mit 97 g α-Terpineol (Isomerengemisch) und 4 g Tetraacetoxydiborat versetzt und intensiv durchmischt. Es entsteht eine strukturviskose und sehr gut druckbare, transparente Paste.

### Beispiel 20:

In einem Glaskolben werden 72,2 g Ethylenglycolmonobutylether (EGB), 3,53 g Bis(dimethoxydimethylsilyl)-1,2-ethan und 12,9 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Die destillierte Mischung wird anschließend mit 97 g α-Terpineol (Isomerengemisch) und 4 g Tetraacetoxydiborat versetzt und intensiv durchmischt. Es entsteht eine strukturviskose und sehr gut druckbare, transparente Paste.

### Beispiel 21:

In einem Glaskolben werden 72,2 g Ethylenglycolmonobutylether (EGB), 4,36 g Dimethoxymethylphenylsilan und 12,9 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Die destillierte Mischung wird anschließend mit 97 g α-Terpineol (Isomerengemisch) und 4 g Tetraacetoxydiborat versetzt und intensiv durchmischt. Es entsteht eine strukturviskose und sehr gut druckbare, transparente Paste.

### Beispiel 22:

In einem Glaskolben werden 72,2 g Ethylenglycolmonobutylether (EGB), 5,8 g Triethoxyphenylsilan und 12,9 g Aluminium-tri-sec-butylat (ASB) vorgelegt und gerührt, bis eine homogene Mischung entsteht. Zu dieser Mischung werden 12,4 g Eisessig und 0,7 g Acetaldoxim in der genannten Reihenfolge unter Rühren hinzugefügt. Anschließend werden 1,9 g Wasser, gelöst in 5 g EGB, tropfenweise hinzugefügt, und die Mischung wird bei 80 °C für vier Stunden refluxiert. Nach dem Erwärmen wird das Hybridsol für zwei Stunden einer Vakuumdestillation bei 70 °C bis zum Erreichen eines Enddrucks von 20 mbar unterworfen. Die destillierte Mischung wird anschließend mit 97 g α-Terpineol (Isomerengemisch) und 4 g Tetraacetoxydiborat versetzt und intensiv durchmischt. Es entsteht eine strukturviskose und sehr gut druckbare, transparente Paste.

## Patentansprüche

1. Verwendung druckbarer Hybridsole und/oder -gele auf Basis von Precursoren anorganischer Oxide zur Herstellung von Solarzellen, **dadurch gekennzeichnet, dass**, Hybridsole und/oder -gele in Form von Zusammensetzungen auf Basis von Precursoren des Siliziumdioxids, Aluminiumoxids und Boroxids im Gemisch
zur lokalen und/oder ganzflächigen, einseitigen Diffusion und Dotierung auf Siliziumoberflächen mittels geeigneter Druckverfahren aufgebracht werden, wobei die druckbaren Hybridsole und/oder -gele selektiv auf geeignete Oberflächen des Substrats aufgedruckt und angetrocknet werden und anschließend mittels eines geeigneten Hochtemperaturprozesses behandelt werden,
wobei der in dem Hybridgel enthaltene Boroxidprecursor an das Substrat zur gezielten Dotierung abgegeben wird,
wobei druckbare Hybridsole und/oder -gele gleichzeitig als Diffusionsbarriere oder als diffusionshemmende Schicht gegenüber unerwünschtem Eindiffundieren von Phosphor wirken, so dass die vorherrschende Dotierung vom p-Typ ist,
wobei eine Dotierung des bedruckten Substrates durch geeignete Temperaturbehandlung erfolgt,
und dass simultan eine Dotierung der unbedruckten Siliziumwaferoberflächen mit Dotanden der entgegengesetzten Polarität mittels konventioneller Gasphasendiffusion induziert wird,
wobei die aufgedruckten Hybridsole und/oder -gele gegenüber den Dotanden der entgegengesetzten Polarität als Diffusionsbarriere wirken, und wobei die in den Hybridsolen und/oder -gelen enthaltenen Precursoren des Aluminiumoxids, ausgewählt sind aus der Gruppe der symmetrisch und asymmetrisch substituierte Aluminiumalkoholate (-alkoxide), Aluminium-tris(-β-diketone), Aluminium-tris(-β-ketoester), Aluminiumseifen, Aluminiumcarboxylate, sowie deren Mischungen.

2. Verwendung gemäß Anspruch 1, **dadurch gekennzeichnet, dass** druckbare Hybridsole und/oder -gele auf Basis von Precursoren des Siliziumdioxids eingesetzt werden, welche ausgewählt sind aus der Gruppe der ein- bis vierfach symmetrisch oder asymmetrisch substituierten Carboxy-, Alkoxy- und Alkoxyalkylsilane, insbesondere Alkylalkoxysilane, worin an das zentrale Siliziumatom mindestens ein Wasserstoffatom gebunden ist, der Carboxy-, Alkoxy- und Alkoxyalkylsilane, insbesondere Alkylalkoxysilane, welche einzelne oder verschiedene gesättigte, ungesättigte verzweigte, unverzweigte aliphatische, alicyclische und aromatische Reste aufweisen, die wiederum an beliebiger Position des Alkyl-, Alkoxid- oder des Carboxyrestes durch Heteroatome, ausgewählt aus der Gruppe O, N, S, Cl und Br funktionalisiert sein können, sowie Mischungen dieser Precursoren.

3. Verwendung gemäß Anspruch 1, **dadurch gekennzeichnet**, dassdruckbare Hybridsole und/oder -gele eingesetzt werden, welche auf Basis von Precursoren des Siliziumdioxids, ausgewählt aus der Gruppe Triethoxysilan, Tetraethylorthosilicat, Triethoxysilan, Ethoxytrimethylsilan, Dimethyldimethoxysilan, Dimethyldiethoxysilan, Triethoxyvinylsilan, Bis[triethoxysilyl]ethan und Bis[diethoxymethylsilyl]ethan, sowie deren Mischungen erhalten worden sind.

4. Verwendung gemäß Anspruch 1, **dadurch gekennzeichnet, dass** druckbare Hybridsole und/oder -gele eingesetzt werde, welche auf Basis von Precursoren des Aluminiumoxids, ausgewählt aus der Gruppe Aluminiumtriethanolat, Aluminiumtrisopropylat, Aluminiumtri-sec-butylat, Aluminiumtributylat, Aluminiumtriamylat und Aluminiumtri-iso-pentanolat, Aluminiumacetylacetonat oder Aluminium-tris(1, 3-cyclohexandionate), Aluminium-monoacetylacetonat-monoalkoholat, Aluminium-tris-(hydroxychinolate), mono- und dibasisches Aluminiumstearat und Aluminiumtristearat, Aluminiumacetat, Aluminiumtriacetat, basisches Aluminiumformat, Aluminiumtriformat und Aluminiumtrioctoat, Aluminiumhydroxid, Aluminiummetahydroxid und Aluminiumtrichlorid, sowie deren Mischungen erhalten worden sind.

5. Verwendung gemäß Anspruch 1, **dadurch gekennzeichnet, dass** druckbare Hybridsole und/oder -gele eingesetzt werden, welche auf Basis von Precursoren des Boroxids, ausgewählt aus der Gruppe der Borsäurealkylester, Borsäureester der funktionalisierten 1, 2-Glykole, Borsäureester der Alkanolamine, gemischten Anhydride aus Borsäure und Carbonsäuren, sowie deren Mischungen erhalten worden sind.

6. Verwendung gemäß Anspruch 1, **dadurch gekennzeichnet, dass** druckbare Hybridsole und/oder -gele eingesetzt werden, welche auf Basis von Precursoren des Boroxids, ausgewählt aus der Gruppe Boroxid, Diboroxid, Triethylborat, Trisopropylborat, Borsäureglykolester, Borsäureethylenglykolester, Borsäureglycerinester, Borsäureester der 2, 3-Dihydroxbernsteinsäure, Tetracetoxydiborat, und Borsäureester der Alkanolamine Ethanolamin, Diethanolamin, Triethanolamin, Propanolamin, Dipropanolamin und Tripropanolamin erhalten worden sind.

7. Verwendung gemäß der einem oder mehreren der Ansprüche 1 bis 6, **dadurch gekennzeichnet, dass** druckbare Hybridsole und/oder -gele eingesetzt werden, welche erhalten werden, indem Precursoren des Siliziumdioxids, Aluminiumoxids und Boroxids im Gemisch unter wasserhaltigen oder wasserfreien Bedingungen mit Hilfe der Sol-Gel-Technik entweder simultan oder sequentiell zu partieller oder vollständiger intra- und/oder interspeziärer Kondensation gebracht werden, wodurch lagerungsstabile, sehr gut druckbare und druckstabile Formulierungen gebildet werden.

8. Verwendung gemäß Anspruch 7, **dadurch gekennzeichnet, dass** druckbare Hybridsole und/oder -gele eingesetzt werden, aus denen während der Kondensationsreaktion flüchtige Reaktionshilfsmittel und Nebenprodukte entfernt worden sind..

9. Verwendung gemäß der Ansprüche 7 oder 8, **dadurch gekennzeichnet, dass** druckbare Hybridsole und/oder -gele eingesetzt werden, welche erhältlich sind durch Einstellung der Precursor-Konzentrationen, des Wasser-, und Katalysatorgehalts, sowie der Reaktionstemperatur und - zeit während der Kondensationsreaktion.

10. Verwendung gemäß der Ansprüche 8 oder 9, **dadurch gekennzeichnet dass** druckbare Hybridsole und/oder -gele eingesetzt werden, welche erhältlich sind durch gezielte Zugabe von kondensationskontrollierenden Agentien in Form von Komplex- und/oder Chelatbildnern, verschiedenen Lösungsmitteln in festgelegten Mengen bezogen auf das Gesamtvolumen, wodurch der Gelierungsgrad der entstehenden Hybridsole und -gele gezielt gesteuert wird.

11. Verwendung gemäß einem oder mehreren der Ansprüche 1 bis 10 zur Herstellung von Solarzellen, **dadurch gekennzeichnet, dass** druckbare Hybridsole und/oder -gele mittels eines Druckverfahrens ausgewählt aus der Gruppe Schleuder- oder Tauch-Beschichtung, Drop-Casting, Curtain- oder Schlitzdüsen-Coating, Screen- oder Flexodrucken, Gravur-, Ink Jet- oder Aerosol Jet-Drucken, Offset-Drucken, Micro Contact-Drucken, elektrohydrodynamischer Dispensen, Walzen- oder Sprüh-Beschichtung, Ultraschall-Sprüh-Beschichtung, Pipe Jet-Drucken, Laser Transfer-Drucken, Tampondruck, Flachbettsiebdruck und Rotationssiebdruck verarbeitet und selektiv oder ganzflächig auf der Substratoberfläche deponiert werden.

12. Verwendung der druckbaren Hybridsole und/oder -gele gemäß einem oder mehreren der Ansprüche 1 bis 10 zur Bearbeitung von Siliziumwafern für photovoltaische, mikroelektronische, mikromechanische und mikrooptische Applikationen.

13. Verwendung der druckbaren Hybridsole und/oder -gele gemäß einem oder mehreren der Ansprüche 1 bis 10 zur Herstellung von PERC-, PERL-, PERT-, IBC-Solarzellen und weiterer, wobei die Solarzellen weitere Architekturmerkmale, wie MWT, EWT, selektiver Emitter, Selektives Front Surface Field, Selektives Back Surface Field und Bifacialität aufweisen.

## Claims

1. Use of printable hybrid sols and/or gels based on precursors of inorganic oxides for the production of solar cells, **characterised in that** hybrid sols and/or gels in the form of compositions based on precursors of silicon dioxide, aluminium oxide and boron oxide in a mixture
are applied to silicon surfaces by means of suitable printing processes for local and/or full-area, one-sided diffusion and doping,
where the printable hybrid sols and/or gels are printed selectively onto suitable surfaces of the substrate and dried and subsequently treated by means of a suitable high-temperature process,
where the boron oxide precursor present in the hybrid gel is released to the substrate for targeted doping,
where printable hybrid sols and/or gels simultaneously act as diffusion barrier or as diffusion-inhibiting layer against undesired diffusion-in of phosphorus, so that the prevailing doping is of the p type,
where doping of the printed substrate is carried out by suitable temperature treatment,
and **in that** doping of the unprinted silicon wafer surfaces with dopants of the opposite polarity is simultaneously induced by means of conventional gas-phase diffusion,
where the printed-on hybrid sols and/or gels act as diffusion barrier against the dopants of the opposite polarity,
and where the precursors of aluminium oxide present in the hybrid sols and/or gels are selected from the group of the symmetrically and asymmetrically substituted aluminium alcoholates (alkoxides), aluminium tris(β-diketones), aluminium tris(β-ketoesters), aluminium soaps, aluminium carboxylates, and mixtures thereof.

2. Use according to Claim 1, **characterised in that** use is made of printable hybrid sols and/or gels based on precursors of silicon dioxide which are selected from the group of the symmetrically or asymmetrically mono- to tetrasubstituted carboxy-, alkoxy- and alkoxyalkylsilanes, in particular alkylalkoxysilanes, in which at least one hydrogen atom is bonded to the central silicon atom, the carboxy-, alkoxy- and alkoxyalkylsilanes, in particular alkylalkoxysilanes, which contain individual or different saturated, unsaturated branched, unbranched aliphatic, alicyclic and aromatic radicals, which may in turn be functionalised at any desired position of the alkyl, alkoxide or carboxyl radical by heteroatoms selected from the group O, N, S, CI and Br, and mixtures of these precursors.

3. Use according to Claim 1, **characterised in that** use is made of printable hybrid sols and/or gels which have been obtained on the basis of precursors of silicon dioxide selected from the group triethoxysilane, tetraethyl orthosilicate, triethoxysilane, ethoxytrimethylsilane, dimethyldimethoxysilane, dimethyldiethoxysilane, triethoxyvinylsilane, bis[triethoxysilyl]ethane and bis[diethoxymethylsilyl]ethane, and mixtures thereof.

4. Use according to Claim 1, **characterised in that** use is made of printable hybrid sols and/or gels which have been obtained on the basis of precursors of aluminium oxide selected from the group aluminium triethanolate, aluminium triisopropylate, aluminium tri-sec-butylate, aluminium tributylate, aluminium triamylate and aluminium triisopentanolate, aluminium acetylacetonate or aluminium tris(1,3-cyclohexanedionate), aluminium monoacetylacetonate monoalcoholate, aluminium tris(hydroxyquinolate), mono- and dibasic aluminium stearate and aluminium tristearate, aluminium acetate, aluminium triacetate, basic aluminium formate, aluminium triformate and aluminium trioctanoate, aluminium hydroxide, aluminium metahydroxide and aluminium trichloride, and mixtures thereof.

5. Use according to Claim 1, **characterised in that** use is made of printable hybrid sols and/or gels which have been obtained on the basis of precursors of boron oxide selected from the group of the alkyl borates, boric acid esters of functionalised 1,2-glycols, boric acid esters of alkanolamines, mixed anhydrides of boric acid and carboxylic acids, and mixtures thereof.

6. Use according to Claim 1, **characterised in that** use is made of printable hybrid sols and/or gels which have been obtained on the basis of precursors of boron oxide selected from the group boron oxide, diboron oxide, triethyl borate, triisopropyl borate, boric acid glycol ester, boric acid ethylene glycol ester, boric acid glycerol ester, boric acid ester of 2,3-dihydroxysuccinic acid, tetraacetoxy diborate, and boric acid esters of the alkanolamines ethanolamine, diethanolamine, triethanolamine, propanolamine, dipropanolamine and tripropanolamine.

7. Use according to one or more of Claims 1 to 6, **characterised in that** use is made of printable hybrid sols and/or gels which are obtained by bringing precursors of silicon dioxide, aluminium oxide and boron oxide in a mixture, either simultaneously or sequentially, to partial or complete intra- and/or interspecies condensation under water-containing or anhydrous conditions with the aid of the sol-gel technique, forming storage-stable, very readily printable and printing-stable formulations.

8. Use according to Claim 7, **characterised in that** use is made of printable hybrid sols and/or gels from which volatile reaction assistants and byproducts have been removed during the condensation reaction.

9. Use according to Claim 7 or 8, **characterised in that** use is made of printable hybrid sols and/or gels which are obtainable by adjustment of the precursor concentrations, the water and catalyst content and the reaction temperature and time during the condensation reaction.

10. Use according to Claim 8 or 9, **characterised in that** use is made of printable hybrid sols and/or gels which are obtainable by specific addition of condensation-controlling agents in the form of complexing and/or chelating agents, various solvents in defined amounts based on the total volume, whereby the degree of gelling of the hybrid sols and gels formed is specifically controlled.

11. Use according to one or more of Claims 1 to 10 for the production of solar cells, **characterised in that** printable hybrid sols and/or gels are processed and deposited on the substrate surface, selectively or over the entire area, by means of a printing process selected from the group spin or dip coating, drop casting, curtain or slot-die coating, screen or flexographic printing, gravure, ink-jet or aerosol-jet printing, offset printing, microcontact printing, electrohydrodynamic dispensing, roller or spray coating, ultrasound spray coating, pipe-jet printing, laser transfer printing, pad printing, flat-bed screen printing and rotary screen printing.

12. Use of the printable hybrid sols and/or gels according to one or more of Claims 1 to 10 for the treatment of silicon wafers for photovoltaic, microelectronic, micromechanical and micro-optical applications.

13. Use of the printable hybrid sols and/or gels according to one or more of Claims 1 to 10 for the production of PERC, PERL, PERT and IBC solar cells and others, where the solar cells have further architectural features, such as MWT, EWT, selective emitter, selective front surface field, selective back surface field and bifaciality.

## Revendications

1. Utilisation de sols et/ou de gels hybrides imprimables qui sont basés sur des précurseurs d'oxydes inorganiques pour la fabrication de cellules solaires, **caractérisée en ce que** les sols et/ou les gels hybrides, sous la forme de compositions qui sont basées sur des précurseurs de dioxyde de silicium, d'oxyde d'aluminium et d'oxyde de bore selon un mélange, sont appliqués sur des surfaces en silicium au moyen de processus d'impression appropriés pour la diffusion et le dopage sur un côté, locaux et/ou pleine aire, dans laquelle :
les sols et/ou les gels hybrides imprimables sont imprimés de façon sélective sur des surfaces appropriées du substrat et sont séchés et subséquemment traités au moyen d'un processus haute température approprié ;
dans laquelle :
le précurseur d'oxyde de bore qui est présent dans le gel hybride est libéré sur le substrat pour un dopage ciblé ; dans laquelle :
les sols et/ou les gels hybrides imprimables opèrent de façon simultanée en tant que barrière de diffusion ou en tant que couche d'inhibition de diffusion à l'encontre d'une diffusion entrante non souhaitée de phosphore, de telle sorte que le dopage qui prévaut soit du type p; dans laquelle :
le dopage du substrat imprimé est mis en oeuvre au moyen d'un traitement thermique approprié ; et **en ce que** :
le dopage des surfaces de tranches en silicium non imprimées à l'aide de dopants de la polarité opposée est déclenché de façon simultanée au moyen d'une diffusion en phase gazeuse classique ; dans laquelle :
les sols et/ou les gels hybrides qui ont été imprimés opèrent en tant que barrière de diffusion à l'encontre des dopants de la polarité opposée ; et dans laquelle :
les précurseurs d'oxyde d'aluminium qui sont présents dans les sols et/ou les gels hybrides sont sélectionnés parmi le groupe qui est constitué par les alcoolates d'aluminium substitués de façon symétrique et de façon asymétrique (alcoxydes), les tris(β-dicétones) d'aluminium, les tris(β-céto-esters) d'aluminium, les savons d'aluminium, les carboxylates d'aluminium, et les mélanges de ceux-ci.

2. Utilisation selon la revendication 1, **caractérisée en ce que** sont utilisés des sols et/ou des gels hybrides imprimables qui sont basés sur des précurseurs de dioxyde de silicium, lesquels sont sélectionnés parmi le groupe qui est constitué par les carboxy-, alcoxy- et alcoxyalkylsilanes mono- à tétrasubstitués de façon symétrique ou de façon asymétrique, en particulier les alkylalcoxysilanes, où au moins un atome d'hydrogène est lié sur l'atome de silicium central, les carboxy-, alcoxy- et alcoxyalkylsilanes, en particulier les alkylalcoxysilanes, lesquels contiennent des radicaux aliphatiques, alicycliques et aromatiques ramifiés, non ramifiés, saturés, non saturés individuels ou différents, lesquels peuvent à leur tour être fonctionnalisés au niveau de n'importe quelle position souhaitée du radical alkyle, alcoxyde ou carboxyle par des hétéroatomes qui sont sélectionnés parmi le groupe qui est constitué par O, N, S, Cl et Br, et les mélanges de ces précurseurs.

3. Utilisation selon la revendication 1, **caractérisée en ce que** sont utilisés des sols et/ou des gels hybrides imprimables qui ont été obtenus sur la base de précurseurs de dioxyde de silicium qui sont sélectionnés parmi le groupe qui est constitué par le triéthoxysilane, le tétraéthylorthosilicate, le triéthoxysilane, l'éthoxytriméthylsilane, le diméthyldiméthoxysilane, le diméthyldiéthoxysilane, le triéthoxyvinylsilane, le bis[triéthoxysilyl]éthane et le bis[diéthoxyméthylsilyl]éthane, et les mélanges de ceux-ci.

4. Utilisation selon la revendication 1, **caractérisée en ce que** sont utilisés des sols et/ou des gels hybrides imprimables qui ont été obtenus sur la base de précurseurs d'oxyde d'aluminium qui sont sélectionnés parmi le groupe qui est constitué par le triéthanolate, le triisopropylate d'aluminium, le tri-sec-butylate d'aluminium, le tributylate d'aluminium, le triamylate d'aluminium et le triisopentanolate d'aluminium, l'acétylacétonate d'aluminium ou le tris(1,3-cyclohexanedionate) d'aluminium, le monoalcoolate de monoacétylacétonate d'aluminium, le tris(hydroxyquinolate) d'aluminium, le stéarate d'aluminium et le tristéarate d'aluminium mono- et dibasiques, l'acétate d'aluminium, le triacétate d'aluminium, le formate d'aluminium basique, le triformate d'aluminium et le trioctanoate d'aluminium, l'hydroxyde d'aluminium, le métahydroxyde d'aluminium et le trichlorure d'aluminium, et les mélanges de ceux-ci.

5. Utilisation selon la revendication 1, **caractérisée en ce que** sont utilisés des sols et/ou des gels hybrides imprimables qui ont été obtenus sur la base de précurseurs d'oxyde de bore qui sont sélectionnés parmi le groupe qui est constitué par les alkylborates, les esters d'acide borique de 1,2-glycols fonctionnalisés, les esters d'acide borique d'alkanolamines, les anhydrures mixtes d'acide borique et d'acides carboxyliques, et les mélanges de ceux-ci.

6. Utilisation selon la revendication 1, **caractérisée en ce que** sont utilisés des sols et/ou des gels hybrides imprimables qui ont été obtenus sur la base de précurseurs d'oxyde de bore qui sont sélectionnés parmi le groupe qui est constitué par l'oxyde de bore, l'oxyde de dibore, le triéthylborate, le triisopropylborate, le glycol ester d'acide borique, l'ester d'éthylène glycol d'acide borique, le glycérol ester d'acide borique, l'ester d'acide borique d'acide 2,3-dihydroxysuccinique, le diborate de tétraacétoxy, et les esters d'acide borique des alcanolamines que sont l'éthanolamine, le diéthanolamine, le triéthanolamine, le propanolamine, le dipropanolamine et le tripropanolamine.

7. Utilisation selon une ou plusieurs des revendications 1 to 6, **caractérisée en ce que** sont utilisés des sols et/ou des gels hybrides imprimables qui sont obtenus en amenant des précurseurs de dioxyde de silicium, d'oxyde d'aluminium et d'oxyde de bore selon un mélange, soit de façon simultanée, soit de façon séquentielle, jusqu'à une condensation intra-et/ou inter-espèces partielle ou complète sous des conditions de contenance d'eau ou anhydres à l'aide de la technique sol-gel, d'où la formation de formulations stables en termes de stockage, pouvant être très aisément imprimées et stables en termes d'impression.

8. Utilisation selon la revendication 7, **caractérisée en ce que** sont utilisés des sols et/ou des gels hybrides imprimables desquels les agents auxiliaires de réaction et les sous-produits volatiles ont été enlevés pendant la réaction de condensation.

9. Utilisation selon la revendication 7 ou 8, **caractérisée en ce que** sont utilisés des sols et/ou des gels hybrides imprimables qui peuvent être obtenus au moyen du réglage des concentrations en précurseur(s), de la teneur en eau et en catalyseur(s) ainsi que de la température de réaction et de la durée de la réaction de condensation.

10. Utilisation selon la revendication 8 ou 9, **caractérisée en ce que** sont utilisés des sols et/ou des gels hybrides imprimables qui peuvent être obtenus au moyen de l'ajout spécifique d'agents de contrôle de condensation sous la forme d'agents complexants et/ou chélatants, de divers solvants selon des quantités définies sur la base du volume total et ainsi, le degré de gélification des sols et des gels hybrides qui sont formés est contrôlé de façon spécifique.

11. Utilisation selon une ou plusieurs des revendications 1 à 10 pour la fabrication de cellules solaires, **caractérisée en ce que** des sols et/ou des gels hybrides imprimables sont traités et déposés sur la surface de substrats, de façon sélective ou sur la totalité de l'aire, au moyen d'un processus d'impression qui est sélectionné parmi le groupe qui est constitué par un dépôt à la tournette/par centrifugation ou par immersion, un dépôt à la goutte, un dépôt par voile ou par filière à fente, une impression par sérigraphie ou par flexographie, une gravure, une impression par jet d'encre ou par jet d'aérosol, une impression offset, une impression par microcontact(s), une délivrance électrohydrodynamique, un dépôt par rouleau ou par pulvérisation, un dépôt par pulvérisation à ultrasons, une impression par jet à délivrance par tuyau, une impression par transfert laser, une impression au tampon, une impression par sérigraphie à lit plat et une impression par sérigraphie rotative.

12. Utilisation des sols et/ou des gels hybrides imprimables selon une ou plusieurs des revendications 1 à 10 pour le traitement de tranches en silicium pour les applications photovoltaïques, micro-électroniques, micromécaniques et microoptiques.

13. Utilisation des sols et/ou des gels hybrides imprimables selon une ou plusieurs des revendications 1 à 10 pour la fabrication de cellules solaires PERC, PERL, PERT et IBC et autres, où les cellules solaires comportent d'autres caractéristiques architecturales, telles que MWT, EWT, émetteur sélectif, champ de surface avant sélectif, champ de surface arrière sélectif et bifacialité.
